# EUROPÄISCHE PATENTSCHRIFT

(11) **EP 1 201 419 B1**
(45) Veröffentlichungstag und Bekanntmachung des Hinweises auf die Patenterteilung: **07.11.2007**
(21) Anmeldenummer: 01122324.5
(22) Anmeldetag: 18.09.2001
(51) Int. Cl.: B32B 38/18, H01L 41/22

(54) **Verfahren zur Herstellung einer ferroelektrischen Vorrichtung**
Method for producing a ferroelectric device
Procédé pour fabriquer un dispositif ferroélectrique

(30) Priorität: 18.09.2000 US 233442 P; 28.11.2000 US 722620
(43) Veröffentlichungstag der Anmeldung: 02.05.2002
(73) Patentinhaber: CATERPILLAR INC., Peoria, Illinois 61629-6490 (US)
(72) Erfinder: Itzhaky, Itzhak, Plainview, New York 11803 (US)
(74) Vertreter: Wagner & Geyer

(56) Entgegenhaltungen:
- EP-A- 0 855 703
- US-A- 5 471 721
- US-A- 5 534 092
- US-A- 5 632 841
- US-A- 5 639 850
- US-A- 6 030 480

## Beschreibung

Die Erfindung betrifft ein Verfahren zur Herstellung einer ferroelektrischen Vorrichtung sowie eine derartrige Vorrichtung.

Ferroelektrische Vorrichtungen haben beträchtliche Bedeutung in vielen Anwendungen. Zum Beispiel sind solche Vorrichtungen als ferroelektrische Sensoren, ferroelektrische Lautsprecher, ferroelektrische Pumpen und ferroelektrische Aktuatoren zum Bereitstellen mechanischer Bewegung gebräuchlich, um einige Anwendungen zu nennen. Aus der US 5,632,841 ist die Herstellung solcher Vorrichtungen durch Verbinden der Vorrichtungsschichten bei erhöhten Temperaturen unter Vakuum und unter Verwendung z. B. einer gekrümmten Form bekannt, um eine gewünschte Krümmung zu schaffen. In Schichten aufgebaute ferroelektrische Vorrichtungen mit unter Spannung stehenden ferroelektrischen Schichten und gebogener Formen haben wünschenswerte Ausgangsbewegungs- und Kraftcharakteristika.

Allerdings kann diese Art der Herstellung unter Spannung stehender ferroelektrischer Vorrichtungen zeitaufwendig sein, weil bestimmte spröde ferroelektrische Schichten, wie z. B. piezokeramische Wafer, nicht plötzlich gebogen werden können, um sich sofort an die Oberfläche einer gekrümmten Form anzupassen. Vielmehr muß, wenn eine gekrümmte Form verwendet wird, solchen spröden ferroelektrischen Schichten gestattet werden, sich allmählich, an die gekrümmte Formoberfläche über eine Zeitperiode bei einer erhöhten Temperatur anzupassen, um den Bruch der ferroelektrischen Schicht zu verhindern. Diese Zeitperiode kann signifikant von dem Typ und den Dimensionen der ferroelektrischen Schicht abhängig sein, und der Gesamtprozeß zur Herstellung von ferroelektrischen Vorrichtungen durch dieses bekannte Verfahren kann sich auf etwa acht Stunden ausdehnen. Die Kosten, die mit solch einem zeitintensiven Prozeß verbundenen sind, sind als hinderlich für die Realisierbarkeit der Herstellung solcher Vorrichtungen in kommerziellem Umfang anzusehen. Zudem erfordert der bekannte Prozeß ein Vakuum, um Gasblasen herauszuziehen, die durch dem verwendeten Klebemittel entweichende flüchtige Stoffe gebildet werden. Dieser Vakuumschritt fügt sich signifikant zu der Gesamtkomplexität des Prozesses hinzu.

Des Weiteren können konventionelle, in Schichten aufgebaute ferroelektrische Vorrichtungen, die gekrümmte Vorrichtungen enthalten, versagen, wenn die ferroelektrische Schicht (typischerweise eine spröde Piezokeramik) Bruch erleidet. Dieser Defekt tritt im großen Umfang auf, nicht weil die ganze ferroelektrische Schicht selbst defekt wird, sondern eher weil die konventionellen Elektroden, die auf der ferroelektrischen Schicht bei Vakuum abgelagert wurden, auch gleichzeitig Bruch erleiden und nicht in der Lage sind, eine elektrische Spannung an einige Gebiete der ferroelektrischen Schicht zu liefern. Ein sich vollständig durch die ferroelektrische Schicht erstreckender Bruch kann auch dazu führen, dass sich Stükke der ferroelektrischen Schicht von der Vorrichtung lösen und einen Prozeß oder benachbarte Komponenten in einer Anwendung verunreinigten.

US-A- 6 030 480 offenbart ein Verfahren zur Herstellung mehrschichtiger piezoelektrischer Aktuatoren und Sensoren mit starkem Deformationsvermögen und wurde als Grundlage für den Oberbegriff des Anspruchs 1 verwendet.

Der Erfindung liegt daher die Aufgabe zugrunde, ein Verfahren anzugeben, mit dem widerstandsfähige ferroelektrische Vorrichtungen, die große mechanische Verschiebungen und große Kräfte erzeugen können, leicht herzustellen sind.

Diese Aufgabe wird erfindungsgemäß gelöst durch die Merkmale des Anspruchs 1. Dabei werden eine Substratschicht, eine ferroelektrische Schicht und eine Expandierschicht in einer flachen Konfiguration bei einer erhöhten Temperatur und unter Druck mit einem Klebstoff verbunden, wobei beim Abkühlen eine Krümmung erlangt wird, bei welcher die ferroelektrische Schicht unter eine kompressive Spannung versetzt wird. Eine der Komponentenschichten, insbesondere die Expandierschicht, wird während des Verbindens der Schichten gemustert, so daß sie eine erhöhte Dehnfähigkeit aufweist.

Vorteilhafte Ausgestaltungen und Weiterbildungen sind Gegenstand der Unteransprüche.

In vorteilhafter Ausgestaltung umfaßt das Verfahren den Schritt des Anordnens einer ferroelektrische Schicht angrenzend an ein Substrat, das ein elektrisch leitendes Material enthält, wobei eine erste Klebeschicht aus Klebematerial zwischen der ferroelektrischen Schicht und dem Substrat angeordnet wird. Die ferroelektrische Schicht und das Substrat haben unterschiedliche Wärmeausdehnungskoeffizienten.

Das Verfahren enthält ferner den Schritt des Anordnens einer Expandierschicht, die ein elektrisch leitendes Material enthält, angrenzend an die ferroelektrische Schicht, wobei eine zweite Klebeschicht aus Klebematerial zwischen der ferroelektrischen Schicht und der Expandierschicht angeordnet wird, und wobei das Substrat, die erste Klebeschicht, die ferroelektrische Schicht, die zweite Klebeschicht und die Expandierschicht einen Zusammenbau bilden.

Das Verfahren enthält ferner den Schritt des Verbindens des Zusammenbaus in einer planaren oder ebenen Konfiguration in einer heißen Presse durch Anwendung eines Druckes auf den Zusammenbau mit einer ersten und zweiten pressenden Oberflächen einer ersten und zweite Platte für eine erste Zeitperiode, wobei der Zusammenbau auf eine erste Temperatur erwärmt wird, die ausreichend ist, um den Zusammenbau zu verbinden. Das Verfahren enthält außerdem den Schritt des Lösens oder Aufhebens des durch die erste und zweite pressende Oberfläche der heißen Presse angewendeten Drucks.

Alternativ umfaßt das Verfahren den Schritt des Anordnens einer auf entgegengesetzten Oberflächen eine erste und zweite Elektrode aufweisenden Betätigungsschicht angrenzend an ein Substrat, wobei eine erste Klebeschicht eines Klebematerials zwischen der Betätigungsschicht und dem Substrat angeordnet wird, und wobei die zweite Elektrode angrenzend an das Substrat angeordnet wird. Die Betätigungsschicht und das Substrat haben unterschiedliche Wärmeausdehnungskoeffizienten. Zusätzlich enthält das Verfahren den Schritt des Anordnens einer Expandierschicht, die ein elektrisch leitendes Material angrenzend an die Betätigungsschicht enthält, wobei eine zweite Klebeschicht des Klebematerials zwischen der Betätigungsschicht und der Expandierschicht angeordnet wird, und wobei das Substrat, die erste Klebeschicht, die Betätigungsschicht, die zweite Klebeschicht und die Expandierschicht einen Zusammenbau bilden.

Das Verfahren enthält ferner den Schritt des Verbindens des Zusammenbaus in einer heißen Presse mit einer ersten und zweiten pressenden Oberflächen unter Anwendung eines Druck auf den Zusammenbau mit den ersten und zweiten pressenden Oberflächen für eine erste Zeitperiode, wobei der Zusammenbau auf eine erste Temperatur erwärmt wird, die ausreichend ist, um den Zusammenbau zu verbinden. Das Verfahren enthält ferner den Schritt des Lösens oder Abstellens des durch die erste und zweite pressende Oberfläche der heißen Presse angewendeten Drucks. Dadurch wird eine Betätigungsvorrichtung geschaffen.

Die mit der Erfindung erzielten Vorteile bestehen insbesondere darin, dass die Herstellung einer unter Spannung stehenden ferroelektrischen Schicht keinen mit der Verwendung von gekrümmten Formen, langen Heizzykluszeiten und oben erwähnten Vakuumschritten verbundenen zeitaufwendigen Verfahrenseinschränkungen unterliegt. Zudem erleidet die in Schichten aufgebaute ferroelektrische Vorrichtung keinen folgenschweren Vorrichtungsdefekt bei Bruch der ferroelektrischen Schicht. Insbesondere ist das Lösen von Chips von gebrochenen Bereichen einer ferroelektrischen Schicht, die einen Prozess oder benachbarte Komponenten während der Verwendung in einer Anwendung kontaminierenden könnten, verhindert oder minimiert. Vorteilhafte Weiterbildungen sind Gegenstand der Unteransprüche.

Nachfolgend werden Ausführungsbeispiele der Erfindung anhand einer Zeichnung näher erläutert. Darin zeigen:
- Fig. 1A: eine perspektivische Darstellung einer ferroelektrischen Vorrichtung gemäß der Erfindung,
- Fig. 1B: eine Querschnittsdarstellung der ferroelektrischen Vorrichtung gemäß Fig. 1A,
- Fig. 2: eine teilweise Querschnittsdarstellung eines Komponentenschichtzusammenbaus oder einer solchen Einheit einer erfindungsgemäßen ferroelektrischen Vorrichtung, die zwischen oberen und unteren Platten einer heißen Presse zum Verbinden der Einheit oder des Zusammenbaus angeordnet ist, wobei die obere Platte der heißen Presse ein Muster enthält, das in die Expandierschicht der Einheit oder den Zusammenbau übertragen wird,
- Fig. 3: eine Querschnittsdarstellung einer Komponentenschichteinheit oder eines solchen Zusammenbaus einer erfindungsgemäßen ferroelektrischen Vorrichtung, die sich auf ein Stützglied stützt und zwischen oberen und unteren Platten einer heißen Presse angeordnet ist,
- Fig. 4A: eine Draufsicht auf ein quadratisches Muster von Nuten, die in einer Expandierschicht einer z. B. in der Fig. 1A gezeigten ferroelektrischen Vorrichtung, wobei die Figur die Krümmung der Vorrichtung nicht wiedergibt,
- Fig. 4B: eine Draufsicht auf ein lineares Muster von Nuten, die in einer Expandierschicht einer z. B. in Fig. 1A gezeigten ferroelektrischen Vorrichtung vorgesehen sind, wobei die Krümmung der Vorrichtung wiederum nicht wiedergegeben ist,
- Fig. 4C: eine ebene Darstellungsansicht eines Rautenmusters von Nuten, die in einer Expandierschicht einer z. B. in Fig. 1A gezeigten ferroelektrischen Vorrichtung vorgesehen sind, wobei die Krümmung der Vorrichtung wiederum nicht wiedergegeben ist,
- Fig. 4D: eine ebene Darstellungsansicht eines hexagonalen Musters von Nuten, die in einer Expandierschicht einer z. B. in Fig. 1A gezeigten ferroelektrischen Vorrichtung vorgesehen sind, wobei die Krümmung der Vorrichtung wiederum nicht wiedergegeben ist,
- Fig. 4E: eine ebene Darstellungsansicht eines oktogonalen Musters von Nuten, die in einer Expandierschicht einer z. B. in Fig. 1A gezeigten ferroelektrischen Vorrichtung vorgesehen sind, wobei die Krümmung der Vorrichtung wiederum nicht wiedergegeben ist,
- Fig. 4F: eine ebene Darstellungsansicht eines kreisförmigen konzentrischen Musters von Nuten, die in einer Expandierschicht einer z. B. in Fig. 1A gezeigten ferroelektrischen Vorrichtung vorgesehen sind, wobei die Krümmung der Vorrichtung wiederum nicht wiedergegeben ist,
- Fig. 5: eine Querschnittsdarstellung einer Platte einer Heißpresse, die eine verformbare pressende Oberfläche zur Verwendung beim Verbinden einer ferroelektrischen Vorrichtung und zur Einprägung der Muster in die Expandierschicht der ferroelektrischen Vorrichtung aufweist.

Die offenbarten Ausführungsformen richten sich an den Bedarf für eine ferroelektrische Vorrichtung, die haltbar, preiswert und im Stande ist, große mechanische Verschiebungen und große Kräfte zu erzeugen. Solche Vorrichtungen haben eine Vielfalt von Verwendungen, einschließlich ferroelektrische Aktuatoren, ferroelektrische Sensoren, ferroelektrische Lautsprecher und ferroelektrische Pumpen. Das erfindungsgemäße Verfahren zur Herstellung solcher Vorrichtungen ist ebenfalls preiswert, weist eine kurze Prozeßzeit auf und ist durch effiziente Verwendung in einer Herstellungseinstellung automatisierbar. Diese und andere Aspekte der Erfindung werden nun detaillierter in Verbindung mit einer Anzahl von exemplarischen Ausführungsformen beschrieben.

Es sollte betont werden, dass die Ausdrücke "enthalten" und "enthaltend", wenn sie in dieser Beschreibung verwendet werden, gebraucht werden, um die Präsenz der festgelegten Merkmale, Schritte oder Komponenten zu spezifizieren. Jedoch schließt die Verwendung dieser Ausdrücke das Vorhandensein oder die Hinzufügung von einem/einer oder mehreren anderen Merkmal(en), Schritt(en), Komponente(n) oder Gruppen nicht aus.

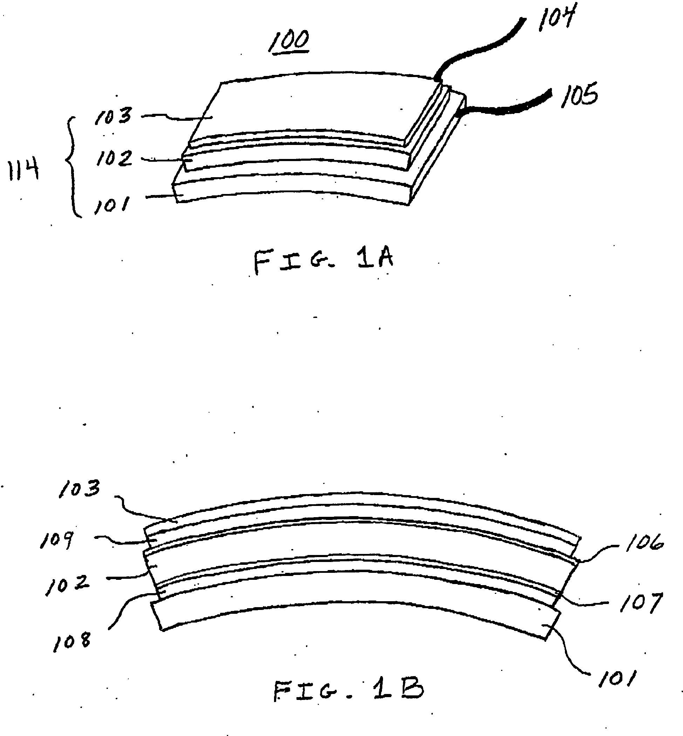

Die Fig. 1A stellt eine ferroelektrische Vorrichtung 100 gemäß einer ersten Ausführungsform der Erfindung dar. Wie in der Fig. 1A dargestellt ist, enthält die ferroelektrische Vorrichtung 100 eine Substratschicht 101 (untere Schicht), eine ferroelektrische Betätigungsschicht 102 (mittlere Schicht) und eine Expandierschicht 103 (obere Schicht). Die Ausdrücke untere Schicht, mittlere Schicht und obere Schicht werden nur aus praktischen Gründen verwendet und sind nicht als beschränkend beabsichtigt. Diese drei Schichten werden nachfolgend auch als Komponentenschichten oder Komponenten 114 bezeichnet. Die Komponentenschichten 114 sind mit dünnen zwischenliegenden Klebeschichten 108 und 109 sicher verbunden, wie in dem Querschnitt in Fig. 1B dargestellt ist.

Wie in der Querschnittsdarstellung gemäß Fig. 1 B gezeigt ist, enthält die ferroelektrische Betätigungsschicht 102 vorzugsweise eine erste Elektrodenschicht 106 und eine zweite Elektrodenschicht 107, die auf entgegengesetzten Oberflächen der ferroelektrischen Betätigungsschicht 102 angeordnet sind. Solche Elektrodenschichten sind während der Herstellung typischerweise auf konventionellen, keramischen Blei-Zirkonat-Titanat- (PZT) Wafern vorgesehen. Solche keramischen PZT Wafer, die mit "Vorelektroden" ausgestattet sind, sind von Anbietern, wie z. B. Morgan Electro Ceramics, Phillips, Motorola, Alpha und CTS, kommerziell verfügbar. Typische Materialien, die für diese Elektrodenschichten verwendet werden, enthalten Gold, Silber, Nickel und Graphit.

Die Expandierschicht oder ausdehnungsfähige Schicht 103 enthält ein elektrisch leitendes Material. Zusätzlich zu anderen Funktionen dient diese Schicht als eine Expandierelektrode oder dehnbare Elektrode. Vorzugsweise enthält die Substratschicht 101 auch ein elektrisch leitendes Material und dient auch als eine Elektrode. Wird jedoch eine ferroelektrische Betätigungsschicht 102 verwendet, die eine erste Elektrode 106 und eine zweite Elektrode 107 aufweist, so ist es nicht erforderlich, dass das Substrat 101 ein elektrisch leitendes Material enthält. Die Dicken der verschiedenen Schichten sind nicht genau oder maßstäblich wiedergegeben.

Die ferroelektrische Vorrichtung 100 kann - wenn die ferroelektrische Betätigungsschicht 102 mit Elektroden 106 und 107 vorgesehen ist und wenn das Substrat nicht elektrisch leitend ist - eine mit der Expandierschicht 103 verbundene elektrische Leitung 104 und eine elektrische Leitung 105 aufweisen, die entweder mit der Substratschicht 101 oder der zweiten Elektrode 107 der ferroelektrischen Betätigungsschicht 102 verbunden ist.

Wie in der Fig. 1A dargestellt ist, weist die ferroelektrische Vorrichtung 100 in deren Endform eine Krümmung auf und ist gestaltet, um eine Druckspannung in der ferroelektrischen Betätigungsschicht 102 in einem nicht vorgespannten Zustand aufzuweisen, d. h. wenn keine Spannung zwischen den zwei elektrischen Leitungen angelegt ist. Die ferroelektrische Vorrichtung 100, die eine verformte oder gespannte ferroelektrische Betätigungsschicht 102 hat, wurde als geeignet befunden, größere Kräfte und größere Versetzungen zu zeigen, als konventionelle ungespannte piezoelektrische Aktuatoren. Das optimale Niveau der Spannung oder Krümmung ist zwar nicht bekannt, Jedoch wurde herausgefunden, dass die Kombination von konventionellen PZT-Materialien für die ferroelektrische Betätigungsschicht 102 und verschiedene Metalle oder Legierungen, wie z. B. Blech und rostfreier Stahl oder Edelstahl, für das Substrat 101 eine vorteilhafte Kombination mit guten Kräften und Biegungscharakteristika für die ferroelektrische Vorrichtung 100 schafft. Es wird erwartet, dass auch andere Kombinationen der Materialien, die die ferroelektrische Betätigungsschicht 102 in einem nicht vorgespannten Zustand unter Druckspannung setzen, auch vorteilhafte Vorrichtungscharakteristika vorsehen werden.

Die ferroelektrische Vorrichtung 100 kann als ein Aktuator durch Anlegen einer Spannung zwischen den elektrischen Leitungen 104 und 105 betrieben werden. Wenn eine Spannung angelegt wird, wird sich die ferroelektrische Betätigungsschicht 102 längs ihrer Länge entweder ausdehnen oder zusammenziehen, wodurch die Krümmung der Vorrichtung entweder ansteigt oder absinkt (die anderen Dimensionen der ferroelektrischen Betätigungsschicht 102 können sich auch verändern). Somit kann, z. B. wenn ein Ende der ferroelektrischen Vorrichtung 100 auf eine Stützstruktur (Trägeraufhängung) montiert ist, eine grob rechtwinklige Verschiebung des anderen Endes der ferroelektrischen Vorrichtung 100 erhalten werden, wenn eine Spannung angelegt wird. In einer alternativen Montagekonfiguration, bei der ein Ende der ferroelektrischen Vorrichtung 100 auf einen Träger montiert wird und das andere Ende teilweise eingeschränkt ist, sich aber bewegen kann, wie z. B. in einer Nut (Balken- oder Strahlmontierung), unterliegt das Zentrum der ferroelektrischen Vorrichtung anstelle des einen Endes einer maximal rechtwinkligen Verstellung.

Ferner kann die ferroelektrische Vorrichtung 100 durch Anlegen von entweder DC- oder AC-Spannungen betrieben werden. Obwohl die ferroelektrische Vorrichtung 100, die in der Fig. 1A dargestellt ist, gekrümmt ist, wird sie vorteilhafterweise durch Verarbeiten von flachen Materialien ohne Verwendung einer Form (z. B. einer gekrümmten Form) hergestellt, wie nachfolgend beschrieben ist.

Wie in den Fig. 1A und 1B dargestellt ist, kann die ferroelektrische Vorrichtung 100 so gestaltet sein, dass die Expandierschicht 103 etwas kleiner als die ferroelektrische Betätigungsschicht 102 ist, welche etwas kleiner als die Substratschicht 101 ist, wobei die Schichten so angeordnet sind, dass die Kanten der Schichten nicht überlappen. Diese Anordnung verhindert oder reduziert zumindest elektrische Lichtbogenbildung über die ferroelektrische Betätigungsschicht 102, wenn eine Spannung zwischen den zwei elektrischen Leitungen angelegt wird. Alternativ könnte die Substratschicht 101 auch etwas kleiner als die ferroelektrische Betätigungsschicht 102 sein, um solche Lichtbogenbildungen zu verhindern. In jedem Fall sind die Kanten der Komponentenschichten vorzugsweise nicht kongruent, so dass ein Lichtbogenbildung vermieden oder reduziert werden kann.

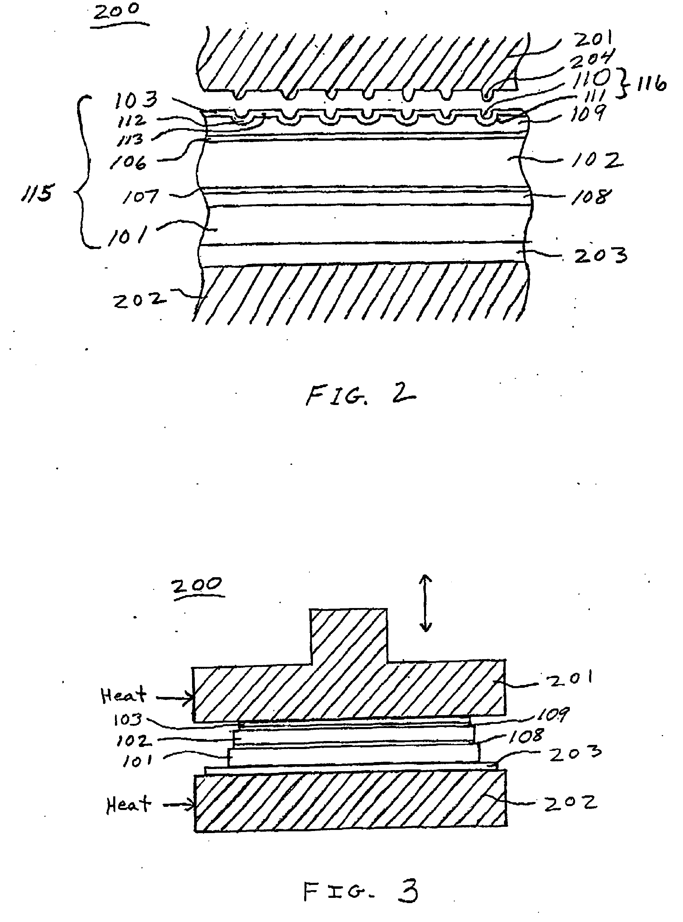

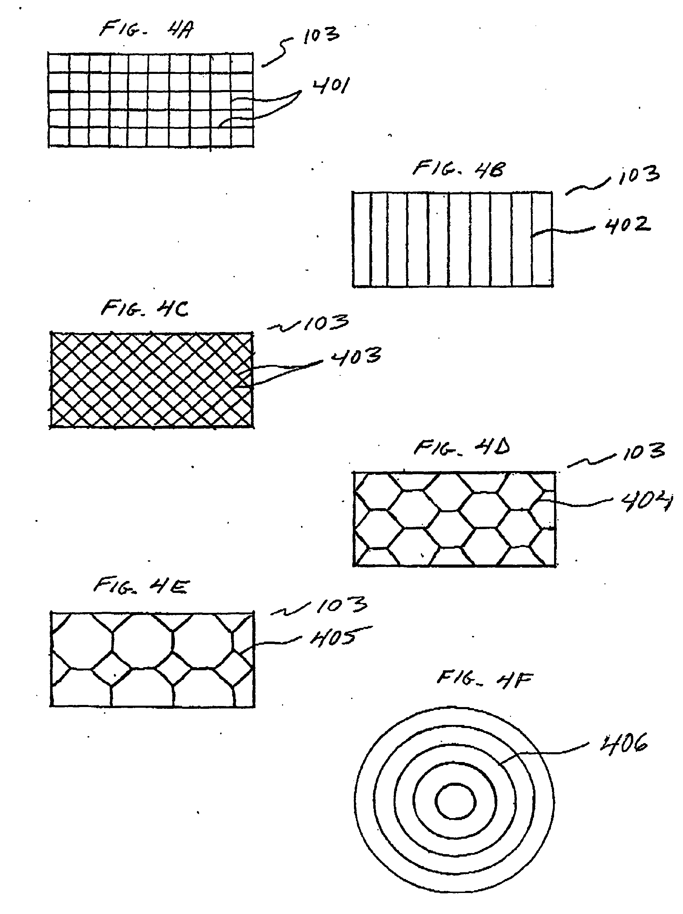

Die Expandierschicht 103 ist gestaltet, um flexibel, expandierbar und elektrisch leitend zu sein. Somit sind dehnbare Metalle und Legierungen für diese Schicht brauchbar. Zusätzlich ist die Expandierschicht 103 vorzugsweise gemustert, wie in der Fig. 2 dargestellt ist. Die Fig. 2 zeigt schematisch die verschiedenen Schichten in teilweisem Querschnitt, abgestützt auf einem Stützglied 203 und angeordnet zwischen einer oberen Platte 201 und einer unteren Platte 202 einer Heißpressapparatur 200. Die Heißpressapparatur 200, wie sie ferner in der Fig. 3 dargestellt ist, wird nachfolgend beschrieben.

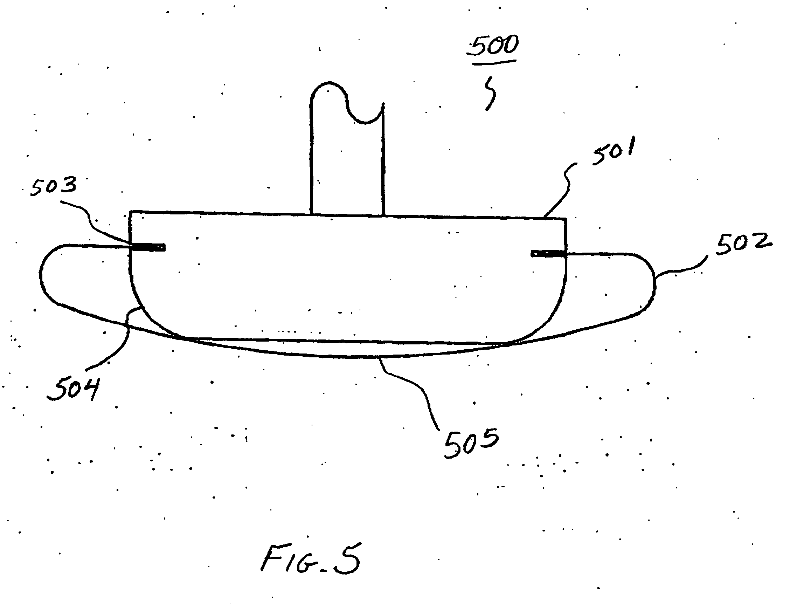

Die Expandierschicht ist vorzugsweise mit einer Mehrzahl von Einkerbungen 110 auf der freiliegenden Oberfläche der Expandierschicht 103 und einer korrespondierenden Mehrzahl von Hervorhebungen oder Vorsprüngen 111 auf der entgegengesetzten Oberfläche der Expandierschicht 103 gemustert, wie in der Fig. 2 dargestellt ist. Die Einzüge oder Einkerbungen 110 und die korrespondierenden Hervorhebungen 111 sollen nachfolgend kurz als Nuten 116 bezeichnet werden. Die Nuten 116 in der Expandierschicht 103, die in der Fig. 2 dargestellt ist, können in einer Mehrzahl von Mustern, so wie sie in einer ebenen Ansicht in den Fig. 4A bis 4F dargestellt sind, angeordnet sein. Es sollte beachtet werden, dass mit den Mustern, die in den Fig. 4A bis 4F dargestellt sind, nicht beabsichtigt ist, weder die Krümmung der Vorrichtung noch die tatsächliche physikalische Größe der damit verbundenen Merkmale wiederzugeben.

Die Fig. 4A zeigt ein Quadratmuster von sich schneidenden Nuten 401, die parallel und rechtwinklig zu den Vorrichtungskanten orientiert sind. Nuten, die in rechtwinkligen Mustern angeordnet sind, können auch verwendet werden. Die Fig. 4B zeigt ein Muster von parallelen Nuten 402, die rechtwinklig zu der Richtung, in welche die Vorrichtung gekrümmt (gebogen) ist, orientiert sind. Die Fig. 4C zeigt ein Diamant- oder Rautenmuster von Nuten 403, die so angeordnet sind, dass die Nuten nicht parallel oder rechtwinklig zu den Vorrichtungskanten orientiert sind. Die Fig. 4D zeigt ein hexagonales Muster der Nuten 404, und die Fig. 4E zeigt ein oktogonales Muster der Nuten 405.

Außerdem kann es wünschenswert sein, ein Muster von konzentrischen Nuten 406 für eine Vorrichtung mit einer insgesamt kreisförmigen Form zu verwenden, wie in der Fig. 4F dargestellt ist. Rauten-, hexagonale und oktogonale Nutenmuster sind bei allen Vorrichtungen von allen Formen vorteilhaft. Es wird angenommen, dass Rauten-, hexagonale und oktogonale Nutenmuster vorteilhaft sein können, weil ein wesentlicher Bruchteil der Nuten entlang der Richtungen orientiert ist, die sich von Richtungen unterscheiden, entlang welchen es wahrscheinlich ist, dass sich potentiell Brüche in der ferroelektrischen Betätigungsschicht 102 entwickeln. Solche Brüche entstehen in der ferroelektrischen Betätigungsschicht 102, wenn sie sich entwickeln, oft entlang der Richtungen, die im wesentlichen rechtwinklig zu der Richtung sind, entlang welcher die ferroelektrische Vorrichtung 100 gekrümmt (gebogen) ist.

Wie in der Fig. 2 dargestellt ist, haben die Einkerbungen 110 vorzugsweise eine vorgegebene Tiefe, die nahezu die nominale Dicke des für die Expandierschicht 103 verwendeten Materials ist. Jedoch ist die Tiefe der Einkerbungen oder Einzüge 110 nicht auf die oben erwähnte Tiefe begrenzt und kann von etwa 50 % bis ein wenig größer als die nominale Dicke des für die Expandierschicht 103 verwendeten Materials reichen. Zusätzlich hat die Dicke der Expandierschicht 103 in gerillten Bereichen 112 vorzugsweise nahezu die gleiche Dicke wie die Expandierschicht in nicht gerillten Bereichen 113. Jedoch kann die Dicke der Expandierschicht 103 in den gerillten Bereichen 112 als ein Ergebnis des heißpressenden/stempelnden Prozesses, der unten beschrieben ist, auch etwas kleiner als die in den nicht gerillten Bereichen 113 sein. Es ist bevorzugt, dass die Expandierschicht 103 während des unten beschriebenen heißpressenden/-stanzenden Prozesses gemustert wird, während welchem die Komponentenschichten verbunden werden. Jedoch können auch vorgemusterte Materialien für die Expandierschicht 103 verwendet werden. Die vorgemusterten Materialien, wie z. B. vorgemusterte Metallfilmschichten, werden typischerweise zum Beispiel durch Stanzen einer Materiallage mit einem gemusterten Metallstempel oder durch Walzen der Materialfolie durch ein Walzwerk mit einer gemusterten Walze hergestellt.

Das Mustern der Expandierschicht 103 versieht diese Schicht mit einer zusätzlichen Fähigkeit, sich während des Betriebs der Betätigungsvorrichtung zu dehnen. Diese zusätzliche Fähigkeit, sich zu dehnen, ist vorteilhaft, weil sie die Expandierschicht 103 vor einem Brechen während des Betriebs bewahrt, sogar wenn die darunter liegende ferroelektrische Betätigungsschicht 102 einen Bruch erleidet. Es sollte bemerkt werden, dass konventionelle ferroelektrische Vorrichtungen oft piezoelektrische Wafer mit darauf liegenden dünnen Elektroden verwenden (z. B. piezoelektrische Wafer, die vorher mit Elektroden ausgestattet sind). Diese dünnen Elektroden können brechen, wenn das darunter liegende piezoelektrische Material (typischerweise eine Piezokeramik) bricht. Somit kann es einen Verlust der elektrischen Verbindung zu Elektrodenbereichen von konventionellen Vorrichtungen geben, wenn der darunter liegende piezoelektrische Wafer bricht.

Im Gegensatz dazu ist die gemusterte Expandierschicht 103 der vorliegenden Erfindung zusätzlich zu jeglicher dünnen Elektrode vorgesehen, die auf der ferroelektrischen Betätigungsschicht 102 vorhanden sein kann (z. B. ein vorkontakteter piezoelektrischer Wafer). Sie kann deshalb als eine elektrisch leitende Brücke für alle Bereiche der ferroelektrischen Betätigungsschicht 102 dienen, einschließlich jeglichen Bereichen, die Bruch erleiden können. Somit wird, wenn die ferroelektrische Betätigungsschicht 102 der vorliegenden ferroelektrischen Vorrichtung 100 bricht, die Expandierschicht 103 fortfahren, elektrische Energie an alle Bereiche der ferroelektrischen Betätigungsschicht 102 zu liefern, und die ferroelektrische Vorrichtung 100 kann, trotz ihres etwas kleineren Optimums, fortfahren zu arbeiten.

Ferner sollte bemerkt werden, dass die Expandierschicht 103 nicht nur als Elektrode, sondern auch anderen Funktionen dient. Speziell dient die Expandierschicht 103 auch als ein Schutz, der die Oberfläche der ferroelektrischen Betätigungsschicht 102 schützt, was die Haltbarkeit der Vorrichtung erhöht. Zusätzlich dient die Expandierschicht 103 auch zum Unterstützen von Bereichen der ferroelektrischen Betätigungsschicht 102, falls diese Bruch erleidet. Diese Funktion ist nützlich, weil die Expandierschicht 103 dadurch Chips der ferroelektrischen Betätigungsschicht 102 vom Ablösen abhalten und Verunreinigen eines Prozesses oder von Nachbarkomponenten während der Verwendung in einer Anwendung vermeiden kann.

Es ist bevorzugt, dass die Expandierschicht 103 dünner als die Substratschicht 101 und die ferroelektrische Betätigungsschicht 102 ist, so dass die Expandierschicht 103 die Bewegung der ferroelektrischen Vorrichtung 100 nicht behindert. Die Kraft- und Biegungscharakteristika der ferroelektrischen Vorrichtung 100 sollten primär durch die Eigenschaften und Dimensionen der Substratschicht 101 und der ferroelektrischen Betätigungsschicht 102 bestimmt sein.

Die Klebeschichten 108 und 109 können unter Verwendung verschiedener Klebematerialien, die Oxydharze und Heißschmelz-Klebstoffe enthalten, gebildet sein. Es ist vorzuziehen, einen Heißschmelz-Klebstoff zu verwenden, der eine Kristallisation bei erhöhten Temperaturen übersteht, wie z. B. NASA's LaRC^{™}-SI oder DuPont's Kapton^{®} . Einige der gewünschten Eigenschaften der LaRC^{™}-SI's, die für die vorliegende Erfindung relevant sind, sind unten angegeben. Dieser Klebstoff ist im Detail in den Artikeln "LaRC^{™}-SI: a soluble aromatic polyimide" von R. G. Bryant (High Performance Polymers Vol. 8, pp. 607-615, 1996) und "Processing and properties of IM7/LaRC^{™}-SI polyimide composites" von T. H. Hou und R. G. Bryant (High Performance Polymers Vol. 9, pp. 437-448, 1997) beschrieben. Die Chemie, auf welcher der LaRC^{™}-SI Klebstoff basiert, ist in dem US-Patent Nr. 5,639,850 beschrieben. LaRC^{™}-SI Klebstoff ist kommerziell verfügbar als Robon^{™} Klebstofffilm von PAR Technologies, Inc. (Newport News, VA).

Wie in den oben erwähnten Artikeln angegeben ist, ist LaRC^{™}-SI ein völlig aromatisches, Hochleistungs-Thermoplastmaterial, das als Heißschmelz-Klebstoff verwendet werden kann. Es ist ein amorphes Polyimid-Polymer-Material und hat eine Glasübergangstemperatur Tg (auch als Erweichungstemperatur bezeichnet) von 248 - 251 °C. Die Glasübergangstemperatur oder Erweichungstemperatur eines Heißschmelz-Klebstoffes wird in der Technik auch oft als die Vulkanisierungstemperatur bezeichnet. Außerdem hat LaRC^{™}-SI einen Wärmeausdehnungskoeffizienten von 4.6 x 10⁻⁵ C⁻¹ (23 - 105 °C) und 6.0 x 10⁻⁵ C⁻¹ (150-200 °C), eine Wärmeleitfähigkeit von 0,244 W/mK und eine Härte (HK50) von 23-27. Es hat gute Klebeeigenschaften und ist strapazierfähig und bruchresistent. Es ist wasserresistent und es ist gegen bestimmte Lösungsmittel resistent, wie z. B. Toluene, Methylen, Chlorid und MEK. Es ist löslich in N-Methylpyrrolidinon (NMP) und kann auf Oberflächen gesprüht oder gestrichen werden, wenn es in NMP gelöst ist. Nach Erwärmung über Tg und Kühlung wird es im wesentlichen unlöslich in NMP, behält aber seine thermophysikalischen Eigenschaften bei, so dass es durch Erwärmung über Tg wieder erweicht werden kann. Es hat eine Schmelzviskosität von 5,5 x 10⁴ Poise bei 350 °C. Es kann als ein Heißschmelz-Klebstoff durch ausreichendes Erhitzen über Tg verwendet werden, um eine ausreichende Benetzung der Verbindungsoberflächen zu erhalten. Seine Verwendung als ein Heißschmelz-Klebstoff wurde in "LaRC^{™}-SI: a soluble aromatic polyimide" von R. G. Bryant (oben bezeichnet) berichtet unter Verwendung einer Verbindungstemperatur von 350 °C und angewendeten Drücken im Bereich von 1 - 21 bar; die Verbindungsstärke wurde als relativ konstant bei angewendeten Drücken größer als 7 bar ermittelt. Der Anmelder hat herausgefunden, dass der LaRC^{™}-SI Heißschmelz-Klebstoff starke Verbindungen zum Verbinden schafft, das bei Temperaturen im Bereich von 325 - 400 °C und gefolgt von einem Kühlen auf unter Tg ausgeführt wurde. Akzeptierbare Verbindungen sind auch beim Verbinden erhalten worden, das bei Temperaturen im Bereich von 300 - 320 °C ausgeführt wurden. Schwächere Verbindungen sind beim Verbinden erhalten worden, das unter 300°C ausgeführt wurde. Es wurde erkannt, dass es vorzuziehen ist, LaRC^{™}-SI Klebstoff in flüssiger Form zu verwenden, die NMP Lösungsmittel enthält. Andere Klebstoffe mit ähnlichen Eigenschaften werden als vorteilhaft bei der Herstellung von ferroelektrischen Vorrichtungen gemäß der vorliegenden Erfindung erwartet.

Die adhäsiven oder Klebeschichten 108 und 109, die in der Fig. 1B dargestellt sind, sind gestaltet, um im wesentlichen dünner zu sein, als die Substratschicht 101 und die ferroelektrische Betätigungsschicht 102 der ferroelektrischen Vorrichtung 100. Die Dicke der Klebeschichten 108 und 109 kann im Bereich von 0,001 mm bis 0,1 mm liegen und sollte so sein, dass - wenn die Vorrichtung verbunden ist - die Klebeschichten 108 und 109 dünn genug sind, um eine gute induktive Kopplung zwischen den benachbarten elektrisch leitenden Schichten (die Expandierschicht 103, die ersten und zweiten Elektroden 106 und 107 und die Substratschicht 101) bereitzustellen. Theoretisch ist es auch möglich, einen elektrisch leitenden Klebstoff oder ein solches Adhäsiv zu verwenden, der/das direkten elektrischen Kontakt zwischen den elektrisch leitenden benachbarten Schichten bereitstellen kann.

Eine Vielfalt von Materialien verschiedener Dicken kann für die Komponentenschichten 114 verwendet werden. Vorteilhafte Materialien für die Substratschicht 101 enthalten Blech (wie Messingblech), rostfreie Stahl oder Edelstahl, Aluminium, elektrisch leitende Kunststoffe und elektrisch leitende Kohlefaserzusammensetzungen. Blech und Edelstahl sind bevorzugte Materialien. Außerdem ist es, wie oben angegeben ist, auch möglich, nichtleitende Materialien für die Substratschicht 101 zu verwenden, in welchem Fall eine elektrische Verbindung zu der zweiten Elektrode 107 der ferroelektrischen Betätigungsschicht 102 zum Betrieb der Vorrichtung hergestellt werden muss. Die Dicke der Substratschicht 101 kann von 0,001 mm bis einige mm reichen, abhängig von der gewünschten Verschiebung oder Verstellung und Kraft. Die bevorzugte Dicke der Substratschicht 101 hängt von dem Kraftbereich und dem Verstellungsbereich ab, der für eine gegebene Anwendung erwünscht ist, und muss in Verbindung mit der Dicke der ferroelektrischen Betätigungsschicht 102 betrachtet werden, weil beide Schichten sich auf diese Eigenschaften der Vorrichtung auswirken werden. Die Auswahl einer geeigneten Dicke und Dimensionen für die Substratschicht 101 und die ferroelektrische Betätigungsschicht 102, um die gewünschten Kraft- und Biegungscharakteristika der Betätigungsvorrichtung zu erreichen, liegt im Ermessen der Fachleute. Dicken von 0,05 mm bis 0,5 mm sind typisch.

Die ferroelektrische Betätigungsschicht 102 kann piezoelektrisches Material, elektrostriktives Material oder ein Material sein, das ähnliche Wirkungen zeigt. Ferner kann die ferroelektrische Betätigungsschicht 102 eine Zusammensetzung von solchen Materialien sein, wie z. B. piezoelektrisches oder elektrostriktives Pulver, Stäbe oder Fasern in einer Polymermatrix. Piezoelektrische Materialien enthalten einkristalline piezoelektrische Materialien, polykristalline piezoelektrische Keramiken (Piezokeramiken) und verschiedene Polymermaterialien, die piezoelektrische Effekte zeigen. Gegenwärtig sind Piezokeramiken vorteilhafter als einkristalline piezoelektrische Materialien oder Polymermaterialien hinsichtlich der hohen Kosten der einkristallinen Materialien und der geringen Leistung der Polymermaterialien. Bevorzugte piezokeramische Materialien enthalten jene basierend auf Blei-Zirkonat-Titanat (PZT). Die PZT-Materialien können auch eine große Vielfalt von zusätzlichen Elementen enthalten, die aus einem substantiellen Teil der Periodentabelle der chemischen Elemente ausgewählt sind. Elektrostriktive Materialien (auch als piezostriktive Materialien bezeichnet) können auch für die ferroelektrische Betätigungsschicht 102 verwendet werden, einschließlich jenen, die auf Blei-Nickel-Niobat (PNN) oder Blei-Magnesium-Niobat (PMN) basieren.

Wie oben angegeben wurde, sind auf PZT basierende Keramiken die bevorzugten Materialien für die ferroelektrische Betätigungsschicht 102. Die Dicke der ferroelektrischen Betätigungsschicht 102 kann von 0,001mm bis einige mm reichen. Die bevorzugte Dicke der ferroelektrischen Betätigungsschicht 102 hängt von dem Kraftbereich und dem Ablenkungs- oder Biegungsbereich ab, die für eine gegebene Anwendung gewünscht ist, und muss in Verbindung mit der Dicke der Substratschicht 101 betrachtet werden, weil beide Schichten sich auf diese Eigenschaften der Vorrichtung auswirken. Das Auswählen geeigneter Dicken und Dimensionen für die Substratschicht und ferroelektrische Betätigungsschicht 102, um gewünschte Kraft- und Biegungscharakteristika zu erreichen, liegt im Ermessen von Fachleuten. Vorzugsweise ist die Dicke der ferroelektrischen Betätigungsschicht größer, als die der Substratschicht 101. Zum Beispiel kann die ferroelektrische Betätigungsschicht 102 eine Dicke von ungefähr dem Zweifachen oder Dreifachen der Dicke der Substratschicht 101 haben.

Die ausdehnbare oder Expandierschicht 103 enthält ein elektrisch leitendes Material. Vorteilhafte elektrisch leitende Materialien enthalten Aluminium und Aluminiumlegierungen, Blech, Edelstahl, elektrisch leitende Kunststoffe und elektrisch leitende Kohlefaserzusammensetzungen. Jedoch ist die Expandierschicht 103 nicht auf diese Auswahlen begrenzt und kann eine Vielfalt von Metallen und Legierungen und Zusammensetzungsmaterialien enthalten. Aluminium und Aluminiumlegierungen sind die bevorzugten Materialien für die Expandierschicht 103. Die Dicke der Expandierschicht 103 kann von 0,001 mm bis 0,1 mm reichen. Die bevorzugte Dicke reicht von 0,01 mm bis 0,025 mm.

Die Gesamtgröße der ferroelektrischen Vorrichtung 100 häng von der gewünschten Anwendung ab. Die typischen Seitenabmessungen sind 3 - 30 mm in der Breite und 10 - 60 mm in der Länge für rechtwinklige oder quadratische Vorrichtungen. Jedoch können auch wesentlich größere Abmessungen verwendet werden. Es ist auch zu beachten, dass Vorrichtungen von kreisartiger Form mit ähnlichen Dimensionen hergestellt werden können. Die Dicke der ferroelektrischen Vorrichtung 100 hängt von den Dicken der individuellen Schichten ab. Die Gesamthöhendimension hängt ferner von der Biegung oder Krümmung der Vorrichtung ab. Ferner ist zu beachten, dass die ferroelektrische Vorrichtung 100 auch eine Mehrzahl von vorkontaktierten ferroelektrischen Betätigungsschichten enthalten kann, die miteinander verbunden sind, statt einer einzelnen ferroelektrischen Betätigungsschicht 102. Eine Vorrichtung mit einem derartigen "Stapel" ist im Stande, eine größere Kraft auszuüben und besitzt eine entsprechend größere Dicke.

Eine zweite Ausführungsform, gemäß der vorliegenden Erfindung, ist ein Verfahren zur Herstellung einer ferroelektrischen Vorrichtung 100, wie jene, die in den Fig. 1A und 1B dargestellt ist. Dieses Verfahren wird im Zusammenhang mit der Herstellung einer ferroelektrischen Vorrichtung beschrieben, die eine gemusterte Expandierschicht 103 (wie Aluminium), eine vorkontaktete ferroelektrische Betätigungsschicht 102 (wie einen PZT-Keramikwafer) und eine Substratschicht 101 (wie rostfreien oder Edelstahl) hat. Obwohl es nicht nötig ist, eine ferroelektrische Betätigungsschicht 102, die mit Elektroden vorher ausgestattet ist, zu verwenden, die vorkontaktet ist, ist die Verwendung von vorkontakteten Wafern für die ferroelektrische Betätigungsschicht 102 bevorzugt.

Zuerst wird die Expandierschicht 103, die ferroelektrischen Betätigungsschicht 102 und die Substratschicht 101 in flache Stücke mit der gewünschten Größe, abhängig von der gewünschten Anwendung geschnitten. Wie vorher erwähnt wurde, können diese Schichten so geschnitten werden, dass ihre Kanten nicht überlappen, um eine Lichtbogenbildung während des Betriebs der Vorrichtung zu verhindern. Das Schneiden dieser Schichten kann durch eine Vielfalt von Techniken ausgeführt werden. Zum Beispiel können die Expandierschicht 103 und die Substratschicht 101 durch Laserschneiden, Stanzen oder andere Verfahren geschnitten werden, so dass die Kanten glatt und frei von Chips sind. Die ferroelektrische Betätigungsschicht 102 kann z. B. durch Verwendung einer schnellrotierenden diamantbesetzten kreisartigen Schneide geschnitten werden, so dass die Kanten des Wafers glatt und frei von Chips sind. Bei einer automatisierten Herstellungseinstellung würde eine große Anzahl von Substratschichten 101, ferroelektrischen Betätigungsschichten 102 und Expandierschichten 103 geschnitten, um einen Vorrat von diesen Materialien zur späteren Verarbeitung zu produzieren. Alternativ könnten vorgeschnittene Materialien von anderen Herstellern erhalten werden.

Im nächsten Schritt werden die Substratschicht 101, die ferroelektrische Betätigungsschicht 102 und die Expandierschicht 103 gereinigt und getrocknet. Fachleute werden erkennen, dass es eine Vielfalt von Reinigungsverfahren gibt, die zur Durchführung dieses Prozesses verwendet werden können. Ein bevorzugter Prozeß beinhaltet eine Ultraschallreinigung der Komponentenschichten 114 in einem wasserbasierenden flüssigen Reinigungsmittel, gefolgt von einem Spülen der Komponenten 114 in einem Bad von deionisiertem oder gefiltertem Wasser, gefolgt von einem Trocknen in einem Ofen. Alle Aspekte dieses Prozesses können in einer automatisierten Weise durch Plazieren der Komponenten 114 auf einem Förderband ausgeführt werden, das ein leinwandähnliches Band enthält, das der Flüssigkeit erlaubt, durch das Förderband zu tropfen. Zusätzlich kann ein zusätzlicher entfettender Schritt unter Verwendung eines organischen Lösungsmittels, wie z. B. Azeton, Trichloroethylen, Methanol, Ethanol oder anderes, vor dem flüssigen Waschmittelbad angewandt werden.

Nach dem Reinigen und Trocknen wird ein Klebstoff auf die Verbindungsoberflächen der Komponenten 114 aufgetragen. Vorzugsweise wird ein thermoplastischer heißschmelzender Polymerklebstoff, wie z. B. LaRC^{™}-SI oder DuPont Kapton^{®} in flüssiger oder fester Form auf eine erste Oberfläche der ferroelektrischen Betätigungsschicht 102, auf die ungemusterte Oberfläche der Expandierschicht 103 und auf eine Oberfläche des Substrats 101 aufgetragen. Wie vorher angegeben wurde, ist LaRC^{™}-SI oder ein thermoplastischer Polymerklebstoff mit ähnlichen Eigenschaften ein bevorzugter Klebstoff bzw. ein bevorzugtes Adhäsiv.

Wenn ein Klebstoff oder Adhäsiv in flüssiger Form verwendet wird, kann der flüssige Klebstoff durch eine Vielfalt von Methoden auf die Komponenten 114 aufgetragen werden, die Siebdruck, Spritzsprühen, Stempeln unter Verwendung eines Tampon- oder Gummistempels oder Spinbeschichtung enthalten, aber nicht darauf beschränkt sind. Im Allgemeinen kann der flüssige Klebstoff unter Verwendung jeglicher Art eines geeigneten Auftragsinstruments aufgetragen werden. Alternativ kann der Klebstoff oder das Adhäsiv in der Form eines festen Blattes zwischen benachbarten zu verbindenden Schichten platziert werden. Fachleute werden erkennen, dass dies Prozesse sind, die unter Verwendung von Förderbändern und Robotern automatisiert werden können, die mit Aufnahme- und Ablegeeinrichtungen ausgestattet sind.

Vorzugsweise werden die Komponenten 114 dann in einem Ofen oder auf einer heißen Platte erwärmt, um Lösungsmittel und andere flüchtige Komponenten von dem Klebstoff oder Adhäsiv zu verdampfen. Die Erwärmung bei einer Temperatur von 150 - 230 °C für 5 - 30 Sekunden wurde als geeignet für den/das LaRC^{™}-SI Klebstoff/Adhäsiv in flüssiger Form herausgefunden. Die Zeit, die zum Verdampfen der flüchtigen Komponenten benötigt wird, ist nicht auf jene oben begrenzt und kann abhängig von dem Klebstoff- oder Adhäsivtyp und davon variieren, ob der Klebstoff oder das Adhäsiv in flüssiger oder fester Form vorliegt. Es ist zu beachten, dass ein bestimmter Betrag von flüchtigen Komponenten in festen Klebstoffen oder Adhäsiven - abhängig von dem speziell verwendeten Klebstoff oder Adhäsiv - vorhanden sein kann. Deshalb ist es wünschenswert, diesen erwärmenden Schritt sogar für feste Klebstoffe oder Adhäsive auszuführen, wenn erwartet wird, dass flüchtige Komponenten vorhanden sind. Im Fall eines flüssigen Klebstoffes oder Adhäsivs ist die Verdampfung des Lösungsmittels typischerweise begleitet von der Bildung von Blasen, die sichtbar auf der Oberfläche der Klebeschicht erscheinen, was angibt, dass die flüchtigen Komponenten ausgetrieben wurden. Wenn die flüchtigen Komponenten im wesentlichen ausgetrieben wurden, hört die Bildung von neuen Blasen an der Oberfläche der Klebe- oder Adhäsivschicht auf, und dieser Zustand erscheint sichtbar. Zu diesem Zeitpunkt kann der Klebstoff im wesentlichen als nichtflüchtig angesehen werden.

Die ferroelektrische Betätigungsschicht 102 wird dann gedreht, um eine zweite (entgegengesetzte) Oberfläche der ferroelektrischen Betätigungsschicht 102 freizulegen, und eine Beschichtung aus flüssigem oder festem thermoplastischem Polymerklebstoff oder -adhäsiv wird auf die zweite Oberfläche aufgetragen. Die ferroelektrische Betätigungsschicht 102 wird dann wieder in der oben erwähnten Weise erhitzt, um die flüchtigen Komponenten zu verdampfen. Es sollte beachtet werden, dass es für die entgegengesetzten Oberflächen der ferroelektrischen Betätigungsschicht 102 nicht nötig ist, in der gerade beschriebenen Weise nacheinander bearbeitet zu werden. Die ferroelektrische Betätigungsschicht 102 kann auch zum Beispiel an ihren Kanten abgestützt werden, so dass beide entgegengesetzten Oberflächen mit Klebstoff oder Adhäsiv beschichtet werden können, bevor die ferroelektrische Betätigungsschicht 102 erwärmt wird, um die flüchtigen Komponenten auszutreiben. Ferner sollte noch beachtet werden, dass die Beschichtungs- und Verdampfungsprozesse in einer automatisierten Weise unter Verwendung von Komponenten 114 auch ausgeführt werden können, die auf einem Förderband platziert sind, wobei ein Roboter unter Verwendung einer Aufnahme- und Ablegevorrichtung, wie eine Vakuumspannvorrichtung, die ferroelektrische Betätigungsschicht 102 umdreht. Obwohl Klebstoffe oder Adhäsive in fester Form, wie ein Klebe- oder Adhäsivfilm, verwendet werden können, ist es vorzuziehen, Klebstoffe oder Adhäsive in flüssiger Form zu verwenden, weil typischerweise festere Klebungen erhalten werden.

Es sollte auch bemerkt werden, dass es möglich ist, die oben erwähnten Komponenten 114 unter Verwendung von Klebstoff zu verbinden, der nur auf einer Oberfläche statt auf beiden zu verbindenden Oberflächen aufgetragen wird. Jedoch wurde herausgefunden, dass ein Aufbringen flüssiger Klebstoffe oder Adhäsive auf beide Oberflächen zu deutlich festeren Verbindungen führt.

Nachdem der Klebstoff aufgetragen worden ist, werden die Komponenten 114 in ihren geeigneten Positionen 114 angeordnet. Das Substrat 101 wird auf einem flachen Trägerglied so platziert, dass die klebstoffbeschichtete Oberfläche des Substrats 101 gegenüber der Trägeroberfläche angeordnet ist. Die ferroelektrische Betätigungsschicht 102 wird dann auf die klebstoffbeschichtete Oberfläche des Substrats 101 an der geeigneten Stelle platziert, und die Expandierschicht 103 wird auf die ferroelektrische Betätigungsschicht 102 an der geeigneten Stelle platziert, so dass die klebstoffbeschichtete Oberflächen in Kontakt sind. Es ist bevorzugt, die Schichten so anzuordnen, dass die Expandierschicht 103 relativ flach oder eben ist, um das Einschließen von Luftblasen zwischen der Expandierschicht 103 und der ferroelektrischen Betätigungsschicht 102 während des Verbindens zu minimieren. Die somit angeordneten drei Komponentenschichten 114 können nachfolgend kurz als ein Komponentenzusammenbau 115 bezeichnet werden.

Die Komponenten 114 werden dann durch Platzieren des oben erwähnten Komponentenzusammenbaus 115, der durch das Trägerglied 203 gehalten ist, in einer heißen Presse 200 und dann durch die Anwendung von Druck bei einer erhöhten Temperatur miteinander verbunden, wie in der Fig. 3 dargestellt ist. Das Trägerglied 203, auf welchem der Komponentenzusammenbau 115 angeordnet ist, wird auf einer vorgeheizten unteren Platte 202 einer heißen Presse 200 platziert, die eine ausreichende Temperatur hat, um das Verbinden zu fördern. Für den Klebstoff oder das Adhäsiv LaRC^{™}-SI kann diese Temperatur von 25 - 400 °C reichen, obwohl 325 - 400 °C bevorzugt ist. Eine vorgeheizte obere Platte 201 der heißen Presse 200 mit der gleichen Temperatur wird dann abgesenkt, so dass sie die expanierende Schicht 103 des Komponentenzusammenbaus 115 berührt. Ein Druck, der von 2 - 10 bar reicht, wird dann für 10 - 300 Sekunden angewendet, um den Komponentenzusammenbau 115 zu verbinden, wie in der Fig. 3 dargestellt ist.

Die tatsächlichen Temperaturen, die für die Platten 201 und 202 der heißen Presse 200 ausgewählt sind, und der Druck, der auf den Komponentenzusammenbau 115 angewandt wird, hängen von den Eigenschaften des speziell verwendeten Klebstoffes, Klebers oder Adhäsivs ab. Im allgemeinen muss ein heißschmelzender Klebstoff ausreichend über seine Erweichungstemperatur (Vulkanisierungstemperatur) erwärmt werden, so dass ausreichende Benetzung der Verbindungsoberflächen erhalten wird, wie vorher angegeben wurde. Es wurde erkannt, dass die Ausführung des Verbindungsprozesses bei einer Temperatur von 325 °C und einem Druck von 6 bar für 60 - 90 Sekunden vorteilhaft ist, wenn LaRC™-SI Adhäsiv verwendet wird. Obwohl das Heißpressen als ein Verbindungsschritt bezeichnet wird, ist erkannbar, dass - wenn Heißschmelz-Klebstoff oder -Adhäsiv verwendet wird - das Verbinden weitergeht, um aufzutreten, wenn sich das Heißschmelz-Adhäsiv verfestigt, wenn es sich abkühlt.

Außerdem können, obwohl der Prozeß als mit derselben Temperatur der oberen und unteren Heißpressenplatten 201 und 202 beschrieben wurde, auch unterschiedliche Temperaturen für jede der Heißpressenplatten 201 und 202 verwendet werden, um die gewünschte Erwärmung des Komponentenzusammenbaus 115 und die gewünschte Benetzung und Verbindung mit dem Klebstoff oder Adhäsiv zu erhalten.

Eine auseinandergezogene Ansicht des Komponentenzusammenbaus 115 und der Platten 201 und 202 der heißen Presse 202 ist in der Fig. 2 gezeigt. Die obere Platte 201 der heißen Presse 200 ist etwas entfernt von der Oberfläche der Expandierschicht 103 gezeigt. Wie in der Fig. 2 dargestellt ist, ist die obere Platte 201 der heißen Presse 200 vorzugsweise mit einer Mehrzahl von Hervorhebungen oder Vorsprüngen 204 gemustert, und dieses Muster wird vorzugsweise in die Expandierschicht 103 während des Verbindungsschritts (Heißpressen/Stempeln) übertragen. Alternativ können auch vorgemusterte Materialien für die Expandierschicht 103 verwendet werden, in welchem Fall es für die obere Platte 201 der heißen Presse 200 nicht notwendig ist, gemustert zu sein. Wie vorher angegeben wurde, verstärkt diese Musterung die Fähigkeit der Expandierschicht 103, sich zu strecken. Wie es auch aus der Fig. 2 offensichtlich ist, ist der darunterliegende Klebstoff der Klebeschicht 109 verdrängt, um die Musterung der Expandierschicht 103 durchzuführen.

Die oberen und unteren Platten 201 und 202 der heißen Presse 200 können aus jeglichem Material mit ausreichender Masse, Wärmekapazität und Festigkeit bestehen, so dass die Komponenteneinheiten 115 die Temperatur der Platten 201 und 202 nicht zerstören oder wesentlich ändern. Entsprechend kann die geeignete Größe der Heißpressenplatten 201 und 202 von der Größe der verarbeiteten ferroelektrischen Vorrichtungen abhängen. Für ferroelektrische Vorrichtungen 100 der oben erwähnten Größe wurden Edelstahlplatten mit ungefähr 15 mm Dicke und breiter als die ferroelektrische Vorrichtung 100 als vorteilhaft herausgefunden. Eisenhaltige Materialien können allgemein verwendet werden.

Nachdem das Verbinden und Mustern durchgeführt wurde, wird die obere Platte 201 der heißen Presse 200 dann nach oben versetzt, um den Komponentenzusammenbau 115 freizugeben. Zu diesem Zeitpunkt, der dem Verbindungsschritt folgt, kann der Komponentenzusammenbau 115 als ein "Vorrichtungszusammenbau" bezeichnet werden, der auch als Merkmal 115 in der Fig. 2 gekennzeichnet ist. Das Trägerglied 203 und der Vorrichtungszusammenbau 115 werden dann von der unteren Platte 202 der heißen Presse 200 entfernt und auf einer kühlenden Oberfläche platziert. Dem Vorrichtungszusammenbau 115 wird dann gestattet, sich auf Raumtemperatur abzukühlen. Alle Aspekte dieses Prozesses können in einer automatisierten Weise unter Verwendung eines Förderbandes und/oder eines Roboters ausgeführt werden, der mit einer Aufnahme- und Ablegevorrichtung ausgerüstet ist.

Bei dem oben beschriebenen Prozeß werden die Platten 201 und 202 der heißen Presse 200 bei konstanten Temperaturen gehalten, bis der Druck von dem Vorrichtungszusammenbau 115 gelöst wird. Jedoch ist dieses Verfahren nicht darauf beschränkt, und es ist bevorzugt, die Temperaturen der Heißpressenplatten 201 und 202 während des Verbindens zu ändern, wenn Heißschmelz-Klebstoffe verwendet werden. Während Druck mit den Platten 201 und 202 der heißen Presse 200 auf einer ausreichenden Temperatur zur Oberflächenbenetzung für eine spezielle Zeitperiode, wie oben beschrieben wurde, aufgebracht wird, ist es wünschenswert, dann die Temperaturen der Platten 201 und 202 auf Werte unterhalb der Erweichungstemperaturen des Heißschmelz-Klebstoffs zu verringern, um den Klebstoff oder das Adhäsiv unter Beibehaltung des Drucks zu verfestigen. Solch eine Kühlung hindert den Klebstoff am Fließen, nachdem der durch die heißen Pressen angewendete Druck entfernt ist. Das Kühlen in dieser Weise hindert die ferroelektrische Betätigungsschicht 102 am Gleiten relativ zu dem Substrat 101, nachdem der durch die heiße Presse angewendete Druck entfernt ist. Bei Verwendung von LaRC^{™}-SI Klebstoff, der einen Erweichungspunkt (Tg) von ungefähr 250 °C hat, wurde als vorteilhaft erkannt, es den Platten der heißen Presse 200 (und somit dem Vorrichtungszusammenbau 115) zu gestatten, auf ungefähr 220 °C abzukühlen, bevor der von der heißen Presse 200 angewendete Druck gelöst wird. Obwohl dieser zusätzliche kühlende Schritt zusätzliche Zeit zu dem Gesamtherstellungsprozeß addiert, können die Platten 201 und 202 entsprechend konstruiert werden, um für ein schnelles Erwärmen und ein schnelles Kühlen zu sorgen, so dass die zusätzliche Prozeßzeit minimiert ist.

Obwohl der oben beschriebene Klebeprozeß ein Trägerglied 203 verwendet, auf welcher die Komponentenschichten 114 zusammengebaut werden können, sollte ferner bemerkt werden, dass das Verfahren nicht darauf beschränkt ist. Es ist möglich, die Komponentenschichten 114 ohne ein Trägerglied 203 direkt auf der unteren Platte 202 der heißen Presse 200 zusammenzubauen.

Eine alternative obere Platte 500 der heißen Presse 200 ist im Querschnitt in der Fig. 5 dargestellt. Wie darin gezeigt ist, enthält die obere Platte 500 ein Plattenglied 501 und eine Verformungsglied 502 in der Form eines federnden Metallblechs. Enden des Verformungsglieds 502 passen in Schlitze 503 des Plattenglieds 501, wodurch das Verformungsglied 502 an dem Plattenglied 501 angebracht wird. Das Plattenglied 501 enthält ferner gekrümmte Bodenränder 504 statt abrupter Ecken. Das Plattenglied 501 kann in der Weise einer konventionellen heißen Pressenplatte erwärmt werden.

Das Verformungsglied 502, das in der Fig. 5 dargestellt ist, ist in der Form eines federnden Metallblechs gewählt, wie z. B. rostfreier Stahl oder Edelstahl, so dasswenn die obere Platte 500 gegen den Komponentenzusammenbau 115 (in der Fig. 5 nicht gezeigt) bewegt wird - das Verformungsglied 502 den Zentrumsbereich der Expandierschicht 103 berührt, bevor andere Bereiche der Expandierschicht 103 berührt werden. So wie die obere Platte 502 fortfährt, sich gegen den Komponentenzusammenbau 115 zu bewegen, berühren zusätzliche Bereiche des Verformungsglieds 502 die Expandierschicht 103, welcher zusätzliche Kontakt radial nach außen von dem Mittelpunkt der Expandierschicht 103 auftritt. Während dieser Bewegung paßt sich das Verformungsglied 502 der flachen Oberfläche des Plattenglieds 501 an. Die gekrümmten Ränder 504 erleichtern diese Bewegung. Diese Bewegung ist vorteilhaft, weil sie es dem Verformungsglied 502 erlaubt, den Komponentenzusammenbau 115 von der Mitte radial nach außen zu pressen, wodurch zwischen der Expandierschicht 103 und der ferroelektrischen Betätigungsschicht 102 das Auftreten von Luftblasen minimiert wird, die sonst zwischen jenen Schichten eingeschlossen werden würden. Vorzugsweise ist das Verformungsglied 502 auf seiner pressenden Oberfläche 505 in der vorher beschriebenen Weise gemustert, um ein gewünschtes Muster von Nuten in die Expandierschicht 103 zu übertragen.

Da sich der Vorrichtungszusammenbau 115 nach dem Entfernen aus der heißen Presse 200 abkühlt, nimmt der Vorrichtungszusammenbau 115 eine gekrümmte Form an, die von der Dicke des Substrats 101 und der ferroelektrischen Betätigungsschicht 102 und von der Differenz zwischen den Wärmeausdehnungskoeffizienten abhängt. Speziell das Substrat 101 und die ferroelektrische Betätigungsschicht 102 werden sich in verschiedenen Maßen zusammenziehen, wenn sich der Vorrichtungszusammenbau 115 abkühlt, was zu einer Krümmung des Vorrichtungszusammenbaus 115 führt. Es sollte bemerkt werden, dass im Zusammenhang mit einer Massenproduktion durch Verwendung derselben Typen der Schichtmaterialien mit denselben Dimensionen alle erhaltenen ferroelektrischen Vorrichtungen die gleiche Krümmung erzielen werden. Wie vorher angegeben wurde, stellt diese gekrümmte Form, die Spannung in der ferroelektrischen Betätigungsschicht 102 erzeugt, ferroelektrische Vorrichtungen 100 bereit, die im Stande sind größere Kräfte und größere Verschiebungen zu zeigen, als durch konventionelle ferroelektrische Vorrichtungen erreicht werden kann.

Nach dem Klebeprozess kann der Vorrichtungszusammenbau 115 "gepolt", d. h. polarisiert werden. Dieser Prozeß kann durch Platzieren des Vorrichtungszusammenbaus 115 in eine Polungsapparatur ausgeführt werden, die einen Ofen und zwei elektrische Leiter enthält, wobei die zwei elektrischen Leiter, wie z. B. elektrisch leitende Federn, eine Spannung über die ferroelektrische Betätigungsschicht 102 anlegen können. Wenn das Substrat 101 elektrisch leitend ist, können die Leiter veranlasst werden, um die Expandierschicht 103 und das Substrat 101 zu kontaktieren. Wenn das Substrat 101 nicht elektrisch leitend ist, kann ein freiliegender Abschnitt der zweiten Elektrode der ferroelektrischen Betätigungsschicht 102 kontaktiert werden, um eine elektrische Verbindung herzustellen. Auf diese Weise kann ein elektrisches Feld über die ferroelektrische Betätigungsschicht 102 bei einer erhöhten Temperatur über dem Curiepunkt des ferroelektrischen Materials angelegt werden. Durch Anlegung der Spannung bei einer erhöhten Temperatur für eine ausreichende Zeitperiode tritt eine Ausrichtung der Dipoldomänen auf und wird eine induzierte Polarisation erreicht. Der Vorrichtungszusammenbau 115 sollte dann auf eine Temperatur ausreichend unter dem Curiepunkt des ferroelektrischen Materials gekühlt werden, um die induzierte Polarisation zu erhalten, bevor die angelegte Spannung weggenommen wird. Die angelegte Spannung kann erhalten bleiben, bis der Vorrichtungszusammenbau 115 Raumtemperatur erreicht.

Die Wahl der Spannung, der Temperatur und der Zeit zum Polen hängt von der spezifischen Art und Dicke des ferroelektrischen Materials ab, das für die ferroelektrische Betätigungsschicht 102 verwendet wird. Für piezoelektrische Materialien schlägt eine Regel vor, dass die während der Polung angelegte Gleichspannung im Bereich von 2,0 - 3,5 kV pro mm Dicke des piezoelektrischen Materials sein sollte. Typischerweise wird die Polung unter Verwendung von Gleichspannungen zwischen 250 - 1500 Volt, Temperaturen von 100 - 200 °C und Zeitperioden von 1 - 60 Minuten für ferroelektrische Betätigungsschichten 102 ausgeführt, die PZT-Materialien von hierin beschriebenen Dicken enthalten. Es sollte bemerkt werden, dass der Polungsprozess auch in einer automatisierten Weise unter Verwendung von Förderbändern und Robotern, die mit Aufnahme- und Ablegeeinrichtungen ausgestattet sind, ausgeführt werden kann, wobei ein Roboter fähig ist, einen Vorrichtungszusammenbau 115 von einem Förderband zu entfernen, ihn in die Polungsapparatur zu platzieren, und dann den Vorrichtungszusammenbau 115 auf ein anderes Förderband zu legen.

Außerdem kann ein Polen durch Wiedererwärmen des Vorrichtungszusammenbaus 115 ausgeführt werden, nachdem er nach dem Verbinden auf Raumtemperatur abgekühlt wurde. Alternativ kann ein Polen ausgeführt werden, während der Vorrichtungszusammenbau 115 noch auf einer erhöhten Temperatur nach dem Verbinden ist, bevor er eine Möglichkeit hatte, sich auf Raumtemperatur abzukühlen.

Nach einem Polen kann der Vorrichtungszusammenbau 115 auf einen Halter montiert werden, der für seine endgültige Anwendung spezifiziert ist, unter Verwendung konventioneller Montagetechniken, wie Löten, Hartlöten, Epoxydharzkleben und Klemmen. Es ist eine Montagetechnik bevorzugt, die für eine mechanische Kraft oder eine Anbringung auf die/an der ferroelektrische(n) Betätigungsschicht 102 und nicht nur bezüglich des Substrats 101 sorgt. Das Montieren in dieser Weise kann potentielle Delamination des Substrats 101 und der ferroelektrischen Betätigungsschicht 102 minimieren. Typische Montagearten enthalten Trägermontage oder Balkenmontage.

Schließlich können elektrische Leitungen, wie z. B. Kabel, so angeschlossen werden, dass ein elektrischer Kontakt zu dem Substrat 101 bzw. der Expandierschicht 103 hergestellt wird. Wenn das Substrat nicht elektrisch leitend ist, sollte elektrischer Kontakt zu der zweiten Elektrodenschicht 107 hergestellt werden, die auf der ferroelektrischen Betätigungsschicht 102 angeordnet ist. Die Leitungen können durch konventionelle Verfahren, wie Löten, Hartlöten und Epoxydharzkleben angebracht werden. Alternativ können Leitungen, die leitendes Silizium oder leitende Federn enthalten, angewandt werden, um einen elektrischen Kontakt zwischen der Vorrichtung und einer elektrischen Quelle einzurichten.

Es sollte bemerkt werden, dass das oben beschriebene Verfahren zur Herstellung ferroelektrischer Vorrichtungen Vorteile verglichen mit anderen Verfahren hat. Insbesondere wird mit dem vorliegenden Verfahren eine endgültige ferroelektrische Vorrichtung 100 erzielt, die durch flaches Verarbeiten der Komponentenschichten 114 in einer flachen Konfiguration ohne die Verwendung einer gekrümmten Form dennoch eine Krümmung und eine gespannte ferroelektrische Betätigungsschicht 102 hat. Ferner ist kein Vakuumschritt erforderlich. Entsprechend erlaubt das vorliegende Verfahren eine drastisch reduzierte Verarbeitungszeit verglichen mit Methoden, die gekrümmte Formen verwenden. Insbesondere kann der vorliegende Verbindungsprozess in der heißen Presse 200 in einer Kürze von 10 - 300 Sekunden ausgeführt werden, um den Komponentenzusammenbau 115 zu verbinden, wogegen Verfahren, die gekrümmte Formen und Autoklaven unter Vakuum verwenden, zum Verbinden mehr als 8 Stunden benötigen können. Somit kann das vorliegende Verfahren auf Grund der gegebenen kurzen Prozesszeit leicht automatisiert werden, um große Stückzahlen von identischen ferroelektrischen Vorrichtungen in einer kurzen Zeitperiode bei signifikant reduzierten Kosten herzustellen. Auch wenn ein Verbindungsprozess verwendet wird, der den Schritt enthält, es den Platten 201 und 202 der heißen Presse 200 zu gestatten, unter den Erweichungspunkt eines heißschmelzenden Klebstoffes abzukühlen, vor dem Aufheben des Druckes, der durch die heiße Presse 200 angewendete wird, wird von dem vorliegenden Verfahren eine signifikant kürzere Arbeitungszeit als jene erwartet, die man in Prozessen vorfindet, die gekrümmte Formen verwenden.

Zusätzlich umfaßt die ferroelektrische Vorrichtung 100, die gemäß dem oben beschriebenen Verfahren hergestellt wurde, die Vorteile einer gemusterten Expandierschicht 103. Wie oben bemerkt wurde, ist diese gemusterte Expandierschicht 103 zusätzlich zu jeglicher vorhandenen dünnen Elektrode 106 und 107 vorgesehen, die bereits auf der ferroelektrischen Betätigungsschicht 102 vorhanden sein kann. Das Muster erlaubt eine größere Dehnung der Expandierschicht 103, und eine solche gemusterte Expandierschicht 103 kann für ein elektrisches Potential an der gesamten ferroelektrischen Betätigungsschicht 102 sorgen, einschließlich Bereichen, die Bruch erleiden können. Zusätzlich sorgt die gemusterte Expandierschicht 103 für eine Schutzfunktion, die die Haltbarkeit der ferroelektrischen Vorrichtung erhöht, und kann auch Bereiche der ferroelektrischen Betätigungsschicht 102 unterstützen, wenn ein Brechen der ferroelektrischen Betätigungsschicht 102 auftritt.

Als ein spezifisches Beispiel hat eine ferroelektrische Vorrichtung 100 zur Verwendung als ein Aktuator bei Textilanwendungen und hergestellt, wie oben beschrieben wurde, die folgenden Attribute. Die ferroelektrische Vorrichtung 100 ist rechtwinklig mit einer Breite von 12 mm und einer Länge von 45 mm. Das Substrat 101 ist Edelstahl mit einer Dicke von 0,13 mm. Die ferroelektrische Betätigungsschicht 102 ist ein kommerziell verfügbarer PZT Keramikwafer mit einer Dicke von 0,35 mm und auf beiden Seiten mit einer Ni-Ag-Legierung vorkontaktiert. Die Expandierschicht 103 ist mit einer kommerziell verfügbaren Aluminiumfolie mit einer Dicke von 0,01 mm ausgebildet. Die adhäsiven oder klebenden Schichten 106 und 107 sind mit LaRC^{™}-SI Klebstoff oder Adhäsiv gebildet und haben nominal eine Dicke von 0,02 mm. Die Expandierschicht 103 ist mit einem Quadratmuster von sich schneidenden Nuten gemustert, wie in den Fig. 2 und 4A dargestellt ist, mit einem Abstand zwischen benachbarten Nuten von etwa 0,075 mm. Die Nuttiefe ist ungefähr 0,01 mm.

Bei Verwendung mit einer Trägermontage ist die ferroelektrische Vorrichtung 100 zu einer Auslenkung an dem freien Ende von etwa 2 mm bei 200 Volt Gleichspannung und zur Ausübung einer Kraft von ungefähr 0,2 Newton im Stande. Bei Verwendung mit einer Balkenmontage ist die ferroelektrische Vorrichtung 100 in der Mitte zu einer Auslenkung von etwa 0,75 mm bei 200 Volt Gleichstrom und zur Ausübung einer Kraft von nahezu 1,25 Newton im Stande.

Spezifische Verarbeitungsbedingungen zur Herstellung der oben bezeichneten ferroelektrischen Vorrichtung 100 sind folgendermaßen. Nach dem Schneiden und Reinigen der Komponentenschichten 114, wie oben beschrieben wurde, wird LaRC^{™}-SI Klebstoff oder Adhäsiv in flüssiger Form (mit NMP als ein Lösungsmittel) auf die verschiedenen Verbindungsoberflächen der Komponentenschichten 114 durch Aufstreichen des Klebstoffes auf die verschiedenen Verbindungsoberflächen aufgetragen. Die Komponentenschichten 114 wurden dann auf ungefähr 220 °C für etwa 30 Sekunden erwärmt, um flüchtige Komponenten (Lösungsmittel) aus dem Klebstoff oder Adhäsiv zu entfernen.

Die Komponentenschichten 114 wurden dann auf einer metallischen Trägerplatte 203 zusammengesetzt und an eine heiße Presse 200, die flache obere und untere Platten 201 und 202 hat, transferiert. Beide Platten waren auf eine Temperatur von 325 °C vorgeheizt und mit Thermokopplungen überwacht. Die kontaktierende Oberfläche der oberen Platte 201 enthält ferner eine Mehrzahl von Hervorhebungen oder Vorsprüngen 204, die in einem quadratischen Muster von sich schneidenden Linien angeordnet sind. Die Hervorhebungen 204 waren ca. 0,01 mm hoch und ca. um 0,075 mm voneinander getrennt. Der Komponentenzusammenbau 115 wurde in der heißen Presse durch Anwendung eines Druckes von etwa 6 bar auf den Zusammenbau für 60 - 90 Sekunden miteinander verbunden. Während dieses Prozesses wurde das Muster, das in der oberen Platte 201 vorhanden war, auf die Aluminiumexpandierschicht 103 übertragen, wie in den Fig. 2 und 4A dargestellt ist. Die Aluminiumexpandierschicht 103 war vorher ungemustert. Der verbundene Vorrichtungszusammenbau 115 wurde von der heißen Presse nach dem Entfernen der oberen Platte 201 von dem Vorrichtungszusammenbau 115 entfernt. Während des Kühlens auf Raumtemperatur erreichte der verbundene Vorrichtungszusammenbau 115 eine leichte Krümmung, wobei die ferroelektrische Betätigungsschicht 102 unter kompressiver Spannung war.

## Patentansprüche

1. Verfahren zur Herstellung einer ferroelektrischen Vorrichtung (100), bei dem eine Substratschicht (101), eine ferroelektrische Schicht (102) und eine Expandierschicht (103) in einer flachen Konfiguration bei einer erhöhten Temperatur und unter Druck mit einem Klebstoff (108,109) verbunden werden, wobei beim Abkühlen eine Krümmung erlangt wird, bei welcher die ferroelektrische Schicht (102) unter eine kompressive Spannung versetzt wird,
**dadurch gekennzeichnet, dass** eine der Komponentenschichten, insbesondere die Expandierschicht (103), während des Verbindens der Schichten gemustert wird, so dass die Expandierschicht (103) eine erhöhte Dehnfähigkeit aufweist.

2. Verfahren nach Anspruch 1, mit folgenden Schritten:
- Anordnen einer ferroelektrischen Schicht (102) angrenzend an ein Substrat (101), das ein elektrisch leitendes Material enthält, wobei eine erste Klebeschicht (108) zwischen der ferroelektrischen Schicht (102) und dem Substrat (101) angeordnet wird, und wobei das Substrat (101) und die ferroelektrische Schicht (102) unterschiedliche Wärmeausdehnungskoeffizienten aufweisen,
- Anordnen einer Expandierschicht (103), die ein elektrisch leitendes Material angrenzend an die ferroelektrische Schicht (102) enthält, wobei eine zweite Klebeschicht (109) zwischen der ferroelektrischen Schicht (102) und der Expandierschicht (103) angeordnet wird, und wobei das Substrat (101), die erste Klebeschicht (108), die ferroelektrische Schicht (102), die zweite Klebeschicht (109) und die Expandierschicht (103) einen Zusammenbau bilden,
- Verbinden des Zusammenbaus zusammen zu einer ebenen Konfiguration in einer heißen Presse (200) mit einer ersten und zweiten Platten (201,202) durch Anwenden eines Druckes auf den Zusammenbau mit der ersten und zweiten pressenden Platte (201,202) für eine erste Zeitperiode, wobei der Zusammenbau auf eine erste Temperatur erwärmt wird, die ausreicht, um den Zusammenbau zu verbinden, und
- Lösen des Druckes, der durch die erste und zweite pressenden Platte (201,202) der heißen Presse (200) angewendet wird.

3. Verfahren nach Anspruch 2, wobei die Oberfläche der ersten Platte (201) mit einer Mehrzahl von Vorsprüngen (204) gemustert ist und ein Muster in die Expandierschicht (103) überträgt, wobei das Muster die Fähigkeit der Expandierschicht (103) erhöht, sich auszudehnen

4. Verfahren nach Anspruch 3, wobei das in die Expandierschicht (103) übertragene Muster eine Mehrzahl von Einkerbungen (110) in einer freiliegenden Oberfläche der Expandierschicht (103) und eine Mehrzahl von entgegengesetzten Hervorhebungen (111) in einer entgegengesetzten Oberfläche der Expandierschicht (103) enthält.

5. Verfahren nach einem der Ansprüche 1 bis 4, wobei das Klebematerial ein heißschmelzender Klebstoff ist, und wobei die erste Temperatur über dem Erweichungspunkt des Klebstoffs ist, so dass die ersten und zweiten Klebeschichten (108,109) die Oberflächen der angrenzenden Schichten (101,102; 102,103) benetzen.

6. Verfahren nach Anspruch einem der Ansprüche 2 bis 5, enthaltend das Kühlen des Schichtzusammenbaus auf eine zweite Temperatur unter dem Erweichungspunkt des Klebematerials vor dem Lösen des durch die erste und zweite Platte (201,202) der Presse (200) aufgewandten Drucks.

7. Verfahren nach Anspruch 5 oder 6, wobei das Klebematerial ein heißschmelzender thermoplastischer Polymerklebstoff ist.

8. Verfahren nach Anspruch 7, wobei der Erweichungspunkt des Klebematerials etwa 250 °C ist, und wobei die erste Temperatur, auf welche der Zusammenbau erwärmt wird, im Bereich von 300°C bis 400°C, vorzugsweise bei etwa 325°C, liegt.

9. Verfahren nach einem der Ansprüche 1 bis 8, ferner enthaltend, bevor das Substrat (101), die ferroelektrische Schicht (102) und die Expandierschicht (103) angeordnet werden, den Schritt des Aufbringens eines flüssigen Klebematerials auf eine erste und eine zweite Oberflächen der ferroelektrischen Schicht (102), auf eine Oberfläche der Expandierschicht (103), die mit der ersten Oberfläche der ferroelektrischen Schicht (102) verbunden wird, und auf eine Oberfläche des Substrats (101), die mit der zweiten Oberfläche der ferroelektrischen Schicht (102) verbunden wird.

10. Verfahren nach Anspruch 9, ferner enthaltend, nach Auftragen des Klebematerials den Schritt des Erwärmens des Substrats (101), der ferroelektrischen Schicht (102) und der Expandierschicht (103) bei einer Verdampfungstemperatur, die ausreichend ist, um das Lösungsmittel aus dem Klebematerial zu verdampfen.

11. Verfahren nach einem der Ansprüche 2 bis 10, wobei die Dicken und Wärmeausdehnungskoeffizienten des Substrats (101) und der ferroelektrischen Schicht (102) ausgewählt werden, um die ferroelektrische Vorrichtung (100) mit einer Krümmung zu versehen, so dass die ferroelektrische Schicht (102) bei einer gekühlten Temperatur unterhalb der ersten Temperatur unter einer kompressiven Spannung steht.

12. Verfahren nach einem der Ansprüche 1 bis 11, ferner enthaltend Polarisieren der ferroelektrischen Schicht (102) durch Anlegen eines elektrischen Feldes quer zur ferroelektrischen Schicht (102) bei einer dritten Temperatur für eine zweite Zeitperiode in einer Weise, die ausreicht, um eine polende Orientierung in der ferroelektrischen Schicht (102) zu induzieren, und durch Kühlen des Zusammenbaus ausreichend unter den Curiepunkt der ferroelektrischen Schicht (102) während des Aufrechterhaltens des elektrischen Feldes, so dass die polende Orientierung bestehen bleibt, nachdem das elektrische Feld entfernt ist.

13. Verfahren nach einem der Ansprüche 1 bis 12, wobei ein Druck im Bereich von etwa 2 bar bis 10 bar, vorzugsweise etwa 6 bar, erzeugt wird.

14. Verfahren nach Anspruch 12 oder 13, wobei die erste Zeitperiode im Bereich von 10 Sekunden bis 300 Sekunden, vorzugsweise im Bereich von 60 Sekunden bis 90 Sekunden, und die zweite Zeitperiode im Bereich von 1 Minute bis 60 Minuten liegt.

15. Verfahren nach Anspruch 1 mit folgenden Schritten:
- Anordnen einer Betätigungsschicht (102), die ein ferroelektrisches Material angrenzend an ein Substrat (101) enthält, wobei eine erste Klebeschicht (10) zwischen der Betätigungsschicht (102) und dem Substrat (101) angeordnet wird, wobei die Betätigungsschicht (102) auf entgegengesetzten Oberflächen angeordnet eine erste und zweite Elektrode () aufweist, wobei die zweite Elektrode () angrenzend an das Substrat (101) angeordnet ist, und wobei das Substrat (101) und die Betätigungsschicht (102) verschiedene Wärmeausdehnungskoeffizienten aufweisen,
- Anordnen einer Expandierschicht (103), die ein elektrisch leitendes Material angrenzend an die Betätigungsschicht (102) enthält, wobei eine zweite Klebeschicht (109) zwischen der Betätigungsschicht (102) und der Expandierschicht (103) angeordnet ist, und wobei das Substrat (101), die erste Klebeschicht (108), die Betätigungsschicht (102), die zweite Klebeschicht (109) und die Expandierschicht (102) einen Zusammenbau bilden,
- Verbinden des Zusammenbaus in einer heißen Presse (200) mit einer ersten und zweiten pressenden Platte (201,202) durch Anwendung eines Druckes auf den Zusammenbau mit der ersten und zweiten Platte (201,202) für eine erste Zeitperiode, wobei der Zusammenbau auf eine erste Temperatur erwärmt wird, die ausreicht, um den Zusammenbau zu verbinden, und
- Lösen des durch die erste und zweite pressende Platte (201,202) der heißen Presse (200) angewendeten Drucks.

16. Ferroelektrische Vorrichtung (100), hergestellt nach einem der Ansprüche 1 bis 15, mit einem Substrat (101), einer ferroelektrische Schicht (102) und einer Expandierschicht (103), wobei eine der Komponentenschichten gemustert ist.

## Claims

1. A method of fabricating a ferroelectric device (100), in which a Substrate layer (101), a ferroelectric layer (102) and an expandable layer (103) are bonded to each other in a flat configuration at an elevated temperature and under pressure using an adhesive (108, 109), wherein upon cooling of the device a curvature is achieved, in which the ferroelectric layer (102) is placed under a compressive strain, **characterized in that** one of said compound layers, in particular said expandable layer (103) is patterned during said bonding of said layers, such that said expandable layer (103) has an increased ability to stretch.

2. The method of claim 1, having the following steps:
arranging a ferroelectric layer (102) adjacent to a substrate (101) including an electrically conducting material, wherein a first adhesive layer (108) is disposed between the ferroelectric layer (102) and the substrate (101), the substrate (101) and the ferroelectric layer (102) having different coefficients of thermal expansion;
arranging an expandable layer (103) including an electrically conductive material adjacent to the ferroelectric layer (102), wherein a second adhesive layer (109) is disposed between the ferroelectric layer (102) and the expandable layer. (103), and wherein the substrate (101), the first adhesive layer (108), the ferroelectric layer (102), the second adhesive layer (109), and the expandable layer (103) form an assembly;
bonding the assembly together in a planar configuration in a hot press (200) having first and second plates (201, 202), by applying a pressure to the assembly using the first and second plates (201, 202) for a first period of time, wherein the assembly is heated to a first temperature sufficient to bond the assembly; and
releasing the pressure applied by the first and second plates (201, 202) of the hot press (200).

3. The method of claim 2, wherein the surface of the first plate (201) is patterned with a plurality of protrusions (204) and transfers a pattern into the expandable layer (103), the pattern enhancing the ability of the expandable layer (103) to stretch.

4. The method of claim 3, wherein the pattern transferred into the expandable layer (103) comprises a plurality of indentations (110) in an exposed surface of the expandable layer (103) and a plurality of opposing protrusions (111) in an opposing surface of the expandable layer (103).

5. The method of any one of claims 1 to 4, wherein the adhesive material is a hot-melt adhesive and wherein the first temperature is above the softening point of the adhesive such that the first and second adhesive layers (108, 109) wet the surfaces of adjacent layers (101, 102; 102,103).

6. The method of any one of claims 2 to 5, further comprising cooling the assembly to a second temperature below the softening point of the adhesive material before releasing the pressure applied by the first and second plates (201, 202) of said press (200).

7. The method of claim 5 or 6, wherein the adhesive material is a hot-melt thermoplastic polymer adhesive.

8. The method of claim 7, wherein the softening point of the adhesive material is approximately 250°C and wherein the first temperature to which the assembly is heated is in the range of 300-400°C, and is preferably approximately 325°C.

9. The method of any one of claims 1 to 8, further comprising, prior to arranging the substrate (101), the ferroelectric layer (102), and the expandable layer (103), the step of applying a liquid adhesive material to a first and a second surface of the ferroelectric layer (102), to a surface of the expandable layer (103) to be bonded to the first surface of the ferroelectric layer (102), and to a surface of the substrate (101) to be bonded to the second surface of the ferroelectric layer (102).

10. The method of claim 9, further comprising, after applying the adhesive material, the step of heating the substrate (101), the ferroelectric layer (102), and the expandable layer (103) at an evaporating temperature sufficient to evaporate the solvent from the adhesive material.

11. The method of any one of claims 2 to 10, wherein the thicknesses and coefficients of thermal expansion of the substrate (101) and the ferroelectric layer (102) are chosen to provide the ferroelectric device (100) with a curvature such that the ferroelectric layer (102) is under a compressive strain at a cooled temperature below the first temperature.

12. The method of any one of claims 1 to 11, further comprising polarizing the ferroelectric layer (102) by applying an electric field across the ferroelectric layer (102) at a third temperature for a second period of time in a manner sufficient to induce an orientation of poles in the ferroelectric layer (102) and by cooling the assembly sufficiently below the Curie point of the ferroelectric layer (102) while maintaining the electric field such that the orientation of poles remains after the electric field is removed.

13. The method of any one of claims 1 to 12, wherein a pressure is in the range of approximately 2-10 bars and particularly at about 6 bars is generated.

14. The method of claim 12 or 13, wherein the first time period is in the range of 10 seconds to 300 seconds and particularly in the range of 60 seconds to 90 seconds, and the second time period is in the range of 1 minute to 60 minutes.

15. The method of claim 1, comprising the following steps:
arranging an actuating layer (102) having a ferroelectric material adjacent to a substrate (101), wherein a first adhesive layer (108) is disposed between the actuating layer (102) and the substrate (101), the actuating layer (102) having first and second electrodes disposed on opposing surfaces thereof, the second electrode being arranged adjacent to the substrate (101), and wherein the substrate (101) and the actuating layer (102) have different coefficients of thermal expansion;
arranging an expandable layer (103) having an electrically conductive material adjacent to the actuating layer (102), wherein a second adhesive layer (109) is disposed between the actuating layer (102) and the expandable layer (103), and wherein the substrate (101), the first adhesive layer (108), the actuating layer (102), the second adhesive layer (109), and the expandable layer (103) form an assembly;
bonding the assembly together in a hot press (200) having first and second pressing plates (201, 202) by applying a pressure to the assembly with the first and second plates (201, 202) for a first period of time, wherein the assembly is heated to a first temperature sufficient to bond the assembly; and
releasing the pressure applied by the first and second pressing plates (201, 202) of the hot press (200).

16. A ferroelectric device, fabricated in accordance to any one of claims 1 to 15, having a substrate (101), a ferroelectric layer (102), and an expandable layer (103), wherein one of said compound layers is patterned.

## Revendications

1. Procédé de fabrication d'un dispositif ferroélectrique (100), dans lequel une couche de substrat (101), une couche ferroélectrique (102) et une couche d'expansion (103) sont assemblées en configuration à plat à température élevée et sous pression à l'aide d'un adhésif (108, 109), en obtenant lors du refroidissement une courbure, dans laquelle la couche ferroélectrique (102) est décalée sous une contrainte de compression,
**caractérisé en ce que** l'une des couches constituantes, en particulier, la couche d'expansion (103), se voit appliquer un motif au cours de l'assemblage des couches de manière qu'elle présente une plus forte extensibilité.

2. Procédé selon la revendication 1, avec les étapes suivantes :
- l'aménagement d'une couche ferroélectrique (102) attenante à un substrat (101), qui contient un matériau électroconducteur, dans lequel une première couche adhésive (108) est aménagée entre la couche ferroélectrique (102) et le substrat (101), et dans lequel le substrat (101) et la couche ferroélectrique (102) présentent différents coefficients de dilatation thermique,
- l'aménagement d'une couche d'expansion (103), qui contient un matériau électroconducteur, attenante à la couche ferroélectrique (102), une deuxième couche adhésive (109) étant aménagée entre la couche ferroélectrique (102) et la couche d'expansion (103) de sorte que le substrat (101), la première couche adhésive (108), la couche ferroélectrique (102), la deuxième couche adhésive (109) et la couche d'expansion (103) forment un ensemble,
- l'assemblage de tout l'ensemble en configuration à plat dans une presse à chaud (200) présentant une première et une seconde plaque (201, 202) en appliquant une pression sur l'ensemble avec la première et la seconde plaque de pressage (201, 202) sur une première période de temps, l'ensemble étant chauffé à une première température qui suffit pour assembler l'ensemble, et
- le relâchement de la pression qui est appliquée par la première et la seconde plaque de pressage (201, 202) de la presse à chaud (200).

3. Procédé selon la revendication 2, dans lequel la surface de la première plaque (201) présente une pluralité de saillies (204) et transfère un motif à la couche d'expansion (103), ce motif augmentant la capacité de la couche d'expansion (103) à s'étirer.

4. Procédé selon la revendication 3, dans lequel le motif transféré à la couche d'expansion (103) contient une pluralité de rainures (110) sur une surface dégagée de la couche d'expansion (103) et une pluralité de reliefs opposés (111) sur une surface située à l'opposé de la couche d'expansion (103).

5. Procédé selon l'une quelconque des revendications 1 à 4, dans lequel le matériau adhésif est une colle thermofusible et dans lequel la première température est supérieure au point de ramollissement de la colle, de sorte que les première et seconde couches adhésives (108, 109) humectent les surfaces des couches attenantes (101, 102 ; 102, 103).

6. Procédé selon l'une quelconque des revendications 2 à 5, comprenant le refroidissement de l'ensemble de couches à une seconde température inférieure au point de ramollissement du matériau adhésif avant de relâcher la pression appliquée par les première et seconde plaques (201, 202) de la presse (200).

7. Procédé selon la revendication 5 ou 6, dans lequel le matériau adhésif est une colle polymère thermoplastique thermofusible.

8. Procédé selon la revendication 7, dans lequel le point de ramollissement du matériau adhésif est d'environ 250 °C et dans lequel la première température à laquelle l'ensemble est chauffé se situe dans la plage de 300 °C à 400 °C, de préférence, d'environ 325 °C.

9. Procédé selon l'une quelconque des revendications 1 à 8, comprenant en outre, avant que le substrat (101), la couche ferroélectrique (102) et la couche d'expansion (103) ne soient aménagées, l'étape visant à appliquer un matériau adhésif liquide sur une première et une deuxième surface de la couche ferroélectrique (102), sur une surface de la couche d'expansion (103), qui est assemblée à la première surface de la couche ferroélectrique (102), et sur une surface du substrat (101), qui est assemblée à la seconde surface de la couche ferroélectrique (102).

10. Procédé selon la revendication 9, comprenant encore, après application du matériau adhésif, l'étape visant à chauffer le substrat (101), la couche ferroélectrique (102) et la couche d'expansion (103) à une température d'évaporation suffisante pour évaporer le solvant du matériau adhésif.

11. Procédé selon l'une quelconque des revendications 2 à 10, dans lequel les épaisseurs et les coefficients de dilatation thermique du substrat (101) et de la couche ferroélectrique (102) sont choisis de manière à conférer une courbure au dispositif ferroélectrique (100), de sorte que la couche ferroélectrique (102) subisse une contrainte de compression à une température de refroidissement inférieure à la première température.

12. Procédé selon l'une quelconque des revendications 1 à 11, comprenant encore la polarisation de la couche ferroélectrique (102) en appliquant un champ électrique transversalement à la couche ferroélectrique (102) à une troisième température sur une seconde période de temps de manière suffisante pour induire une orientation polarisante dans la couche ferroélectrique (102), et en refroidissant l'ensemble à une température suffisamment inférieure au point de Curie de la couche ferroélectrique (102), tandis que l'on maintient le champ électrique, de sorte que l'orientation polarisante reste conservée une fois que le champ électrique éliminé.

13. Procédé selon l'une quelconque des revendications 1 à 12, dans lequel on génère une pression dans la plage d'environ 2 bars à 10 bars, de préférence, d'environ 6 bars.

14. Procédé selon la revendication 12 ou 13, dans lequel la première période de temps se situe dans la plage de 10 secondes à 300 secondes, de préférence, dans la plage de 60 secondes à 90 secondes, et la seconde période de temps se situe dans la plage de 1 minute à 60 minutes.

15. Procédé selon la revendication 1, comportant les étapes suivantes :
- l'aménagement d'une couche active (102), qui contient un matériau ferroélectrique, en position attenante à un substrat (101), une première couche adhésive (10) étant aménagée entre la couche active (102) et le substrat (101), la couche active (102) présentant une première et une deuxième électrode () aménagées sur des surfaces opposées, la deuxième électrode () étant aménagée en position attenante au substrat (101) et le substrat (101) et la couche active (102) présentant différents coefficients de dilatation thermique,
- l'aménagement d'une couche d'expansion (103), qui contient un matériau électroconducteur en position attenante à la couche active (102), une seconde couche adhésive (109) étant aménagée entre la couche active (102) et la couche d'expansion (102), et le substrat (101), la première couche adhésive (108), la couche active (102), la seconde couche adhésive (109) et la couche d'expansion (103) formant un ensemble,
- l'assemblage de l'ensemble dans une presse à chaud (200) présentant une première et une seconde plaque (201, 202) en appliquant une pression sur l'ensemble à l'aide de la première et de la seconde plaque (201, 202) sur une première période de temps, l'ensemble étant chauffé à une première température suffisante pour assembler l'ensemble, et
- le relâchement de la pression appliquée par les première et seconde plaques (201, 202) de la presse à chaud (200).

16. Dispositif ferroélectrique (100) fabriqué selon l'une quelconque des revendications 1 à 15, comportant un substrat (101), une couche ferroélectrique (102) et une couche d'expansion (103), dans lequel l'une des couches composantes présente un motif.
